# EUROPÄISCHE PATENTSCHRIFT

(11) **EP 1 950 854 B1**
(45) Veröffentlichungstag und Bekanntmachung des Hinweises auf die Patenterteilung: **01.08.2012**
(21) Anmeldenummer: 07024806.7
(22) Anmeldetag: 20.12.2007
(51) Int. Cl.: H01S 5/42, G01S 7/481, G01S 17/10, H01S 5/183, H01S 5/30, H01S 5/10, H01S 5/00

(54) **Messanordnung und Messsystem**
Measuring device and measuring system
Dispositif de mesure et système de mesure

(30) Priorität: 25.01.2007 DE 102007003806; 12.03.2007 DE 102007011804
(43) Veröffentlichungstag der Anmeldung: 30.07.2008
(73) Patentinhaber: OSRAM Opto Semiconductors GmbH, 93055 Regensburg (DE)
(72) Erfinder: Müller, Martin, 93128 Regenstauf (DE)
(74) Vertreter: Epping - Hermann - Fischer

(56) Entgegenhaltungen:
- WO-A-01/63708
- WO-A-2006/044758
- US-A1- 2002 131 461
- US-A1- 2003 053 506
- US-A1- 2006 285 566

## Beschreibung

Die vorliegende Erfindung betrifft eine Messanordnung sowie ein Messsystem mit der Messanordnung.

Diese Patentanmeldung beansprucht die Priorität der deutschen Patentanmeldungen 10 2007 003 806.4 und 10 2007 011 804.1 .

In derartigen Messanordnungen, die beispielsweise zur Entfernungsmessung oder zur Geschwindigkeitsmessung eingesetzt werden können, werden vielfach Halbleiterlaserbauelemente verwendet.

In der Druckschrift WO 2006/044758 ist ein optisches Detektionssystem mit einer VCSEL-Matrix als Emitterquelle beschrieben.

Aus der Druckschrift WO 01/63708 ist ein Bauelement bekannt, bei dem aktive Bereiche über Tunnelübergänge miteinander verbunden sind.

Eine Aufgabe der vorliegenden Erfindung ist es, eine Messanordnung und ein Messsystem mit erhöhter Effizienz anzugeben, welches sich kostengünstig herstellen lässt.

Diese Aufgabe wird mit den Gegenständen der unabhängigen Patentansprüche gelöst. Ausgestaltungsformen und Weiterbildungen der Erfindung sind Gegenstand der Unteransprüche.

In einer beispielhaften Ausführungsform der Erfindung umfasst eine Messanordnung eine Strahlungseinrichtung, die wenigstens ein erstes oberflächenemittierendes Halbleiterbauelement mit einer vertikalen Emissionsrichtung aufweist. Das Halbleiterbauelement umfasst dabei einen Halbleiterkörper mit einer Mehrzahl von zur Erzeugung von Strahlung geeigneten, in vertikaler Richtung voneinander beabstandet angeordneten aktiven Bereichen. Zwischen zwei aktiven Bereichen aus der Mehrzahl der aktiven Bereiche ist ein Tunnelübergang im Halbleiterkörper monolithisch integriert. Im Betrieb des Halbleiterbauelements sind die beiden aktiven Bereiche mittels des Tunnelübergangs elektrisch leitend verbunden. Die Messanordnung umfasst ferner eine Detektionseinrichtung zur Detektion reflektierter Strahlung und eine Auswerteschaltung, die eingerichtet ist zur Steuerung der Strahlungseinrichtung und der Detektionseinrichtung sowie zur Verarbeitung eines Detektionsergebnisses der Detektionseinrichtung.

Im Betrieb der Messanordnung wird beispielsweise gesteuert von der Auswerteschaltung Strahlung, vorzugsweise Laserstrahlung, vom Halbleiterbauelement der Strahlungseinrichtung emittiert. Die Emission der Strahlung kann beispielsweise pulsförmig erfolgen. Wenn die Strahlung auf ein Hindernis oder ein anderes Objekt trifft, welches für die Wellenlänge der Strahlung undurchlässig ist, kommt es in der Regel zu einer Reflexion der emittierten Strahlung. Die Reflexion kann gerichtet oder diffus erfolgen, so dass ein Teil der reflektierten Strahlung in Richtung der Detektionseinrichtung zurückgestrahlt wird, welche beispielsweise in der Nähe der Strahlungseinrichtung angeordnet ist. Die Detektionseinrichtung kann jedoch auch beabstandet von der Strahlungseinrichtung vorgesehen werden.

Die reflektierte Strahlung kann von der Detektionseinrichtung detektiert und beispielsweise als Detektionssignal an die Auswerteschaltung weitergegeben werden. Das Detektionsergebnis und die Zeit, die zwischen dem Aussenden der Strahlung durch die Strahlungseinrichtung und dem Detektieren der reflektierten Strahlung in der Detektionseinrichtung vergangen ist, kann im Zusammenhang mit der Ausbreitungsgeschwindigkeit der Strahlung, welche üblicherweise der Lichtgeschwindigkeit entspricht, zur Entfernungsmessung zwischen der Messanordnung und dem reflektierenden Objekt verwendet werden.

Mittels der Mehrzahl von aktiven Bereichen kann die im Halbleiterkörper erzeugte Strahlungsleistung und hierüber mit Vorteil ebenso die aus dem Halbleiterkörper ausgekoppelte Strahlungsleistung erhöht werden. Insbesondere kann so auch die aus dem Halbleiterkörper ausgekoppelte Strahlungsleistung bezogen auf den Flächeninhalt einer Strahlungsauskoppelfläche des Halbleiterbauelements erhöht werden.

Ferner ist bei dem Halbleiterbauelement aufgrund der Mehrzahl von aktiven Bereichen der elektrische Widerstand, beispielsweise der Widerstand eines nur einmal vorhandenen Bragg-Spiegels, im Halbleiterkörper auf eine Mehrzahl von aktiven Bereichen verteilt, sodass der Widerstand des Halbleiterkörpers pro aktiven Bereich gegenüber einem Halbleiterkörper mit einer geringeren Anzahl an aktiven Bereichen verringert ist. Der von einem Betriebsstrom pro aktivem Bereich zu überwindende Widerstand kann so verringert werden. Die Konversionseffizienz von dem Halbleiterkörper zugeführter elektrischer Leistung in Strahlungsleistung wird in der Folge erhöht.

Insgesamt zeichnet sich das Halbleiterbauelement demnach durch vereinfacht erhöhbare Effizienz aus. Dies wirkt sich auch auf die Effizienz der Messanordnung aus.

Bevorzugt sind zwei aktive Bereiche zur Erzeugung von Strahlung der gleichen Wellenlänge ausgebildet. Dies kann durch gleichartige Ausführung der aktiven Bereiche, zum Beispiel mittels gleicher Materialien und/oder des gleichen strukturellen Aufbaus der aktiven Bereiche, vereinfacht erreicht werden. Alternativ sind die aktiven Bereiche zur Erzeugung von Strahlung unterschiedlicher Wellenlänge ausgeführt.

Über den Tunnelübergang kann die elektro-optische Konversionseffizienz von in den Halbleiterkörper injizierten Ladungsträgern in Strahlung (Photonen) mittels der über den Tunnelübergang elektrisch leitend verbundenen aktiven Bereiche, das heißt die Effizienz der elektro-optischen Konversion erhöht werden.

Ein in dem einen aktiven Bereich unter Strahlungserzeugung rekombinierendes Elektron, kann durch den Tunnelübergang, der beispielsweise als, insbesondere im Betrieb des Halbleiterbauelements in Durchlassrichtung bezüglich der aktiven Bereiche, in Sperrrichtung gepolte Tunneldiode ausgeführt ist, hindurch tunneln und in den anderen aktiven Bereich gelangen.

Der Tunnelübergang ist bevorzugt derart ausgebildet, dass Elektronen nach strahlender Rekombination aus dem Valenzband des einen aktiven Bereichs ins Leitungsband des anderen aktiven Bereichs tunneln und somit wiederum zur Strahlungserzeugung in dem letztgenannten aktiven Bereich genutzt werden können. Ein Ladungsträger kann somit mehrfach, das heißt in einer Mehrzahl von aktiven Bereichen, zur Strahlungserzeugung genutzt werden.

Der Tunnelübergang weist bevorzugt zwei Tunnel-Halbleiterschichten unterschiedlichen Leitungstyps auf. Ferner ist der Tunnelübergang bevorzugt im Halbleiterkörper zwischen zwei Halbleiterschichten des Halbleiterkörpers unterschiedlichen Leitungstyps angeordnet, die besonders bevorzugt an den Tunnelübergang angrenzen. Die Halbleiterschichten des Tunnelübergangs weisen bevorzugt eine höhere Dotierstoffkonzentration auf als die jeweilige an den Tunnelübergang angrenzende Halbleiterschicht des Halbleiterkörpers des jeweils gleichen Leistungstyps. Weiterhin grenzen die Tunnel-Halbleiterschichten des Tunnelübergangs bevorzugt jeweils an eine Halbleiterschicht des Halbleiterkörpers an, die den gleichen Leitungstyp aufweist wie die angrenzende Tunnelschicht.

Zwischen zwei der aktiven Bereiche ist ein frequenzselektives Element angeordnet. Über das frequenzselektive Element kann die Intensitätsverteilung von Strahlung im Halbleiterkörper beeinflusst werden. Bevorzugt wird die Intensitätsverteilung derart beeinflusst, dass die Intensitätsverteilung, insbesondere deren einhüllende Kurve, gemäß einer vorgegebenen Intensitätsverteilung beziehungsweise einer vorgegebenen Kurve geformt ist. Insbesondere kann die Intensitätsverteilung derart beeinflusst werden, dass die Intensität, die in einem absorbierendem, nicht zur Strahlungserzeugung ausgebildeten Element im Halbleiterkörper absorbiert werden kann, gegenüber einem gleichartig ausgebildeten Halbleiterkörper, bei dem jedoch auf das frequenzselektive Element verzichtet ist, verringert ist. Die im Halbleiterkörper absorbierte Strahlungsleistung kann so verringert werden, wodurch die ausgekoppelte Strahlungsleistung erhöht wird.

Das frequenzselektive Element ist zwischen den aktiven Bereichen angeordnet, die über den Tunnelübergang elektrisch leitend verbunden sind. Im Bereich des Tunnelübergangs ist so aufgrund der relativen räumlichen Nähe zum frequenzselektiven Element die Strahlungsintensität vereinfacht verringerbar. Ein Tunnelübergang weist in der Regel ein hohes Absorptionsvermögen für im Halbleiterkörper erzeugte Strahlung, insbesondere durch freie Ladungsträger, auf, sodass eine Minderung der Intensität im Bereich des Tunnelübergangs mittels des frequenzselektiven Elements von besonderem Vorteil ist.

Bevorzugt ist das frequenzselektive Element derart ausgebildet, dass die Intensität der erzeugten Strahlung im Halbleiterkörper innerhalb des frequenzselektiven Elements gemindert ist. Zweckmäßigerweise ist der Tunnelübergang vom frequenzselektiven Element umgeben oder in dieses eingebettet.

In einer weiteren bevorzugten Ausgestaltung weist das Halbleiterbauelement einen internen Resonator auf oder ist für den Betrieb mit einem externen Resonator ausgebildet. Bevorzugt ist das Halbleiterbauelement zum Betrieb als elektrisch gepumptes Halbleiterlaserbauelement mit einem Resonator ausgebildet. Besonders bevorzugt ist das Halbleiterbauelement zum Betrieb als VCSEL (VCSEL: vertical cavity surface emitting laser) mit einem internen Resonator ausgebildet.

Im Betrieb des Halbleiterbauelements mit Resonator baut sich im Resonator ein Strahlungsfeld, insbesondere ein Feld stehender Wellen (Stehwellenfeld) auf, das zumindest zum Teil durch stimulierte Emission in den aktiven Bereichen verstärkt werden kann. Die verstärkte Strahlung kann als kohärente Laserstrahlung aus dem Resonator auskoppeln.

In einer weiteren bevorzugten Ausgestaltung ist der Resonator mittels eines ersten Resonatorspiegels und eines zweiten Resonatorspiegels gebildet und vorzugsweise begrenzt. Der erste Resonatorspiegel und/oder der zweite Resonatorspiegel können als, insbesondere monolithisch im Halbleiterkörper integrierter, Braggspiegel (Resonator-Braggspiegel) ausgeführt sein.

Spiegel, mittels derer der Resonator gebildet ist, sind bevorzugt mit einer hohen Reflektivität, beispielsweise von 99% oder größer, etwa 99,9% oder größer ausgebildet, wobei einer der Spiegel als Auskoppelspiegel von Strahlung aus dem Resonator dient und hierzu bevorzugt eine entsprechend geringere Reflektivität aufweist. Die Reflektivität des Auskoppelspiegels ist hierbei zweckmäßigerweise derart groß gewählt, dass im Betrieb des Bauelements Lasertätigkeit erreichbar ist.

Der Resonator ist bevorzugt als gemeinsamer Resonator für eine Mehrzahl von aktiven Bereichen, zum Beispiel zwei oder mehr aktive Bereichen, die jeweils als Verstärkungsbereiche für Strahlung im Halbleiterkörper ausgebildet und innerhalb des diesen aktiven Bereichen gemeinsamen Resonators angeordnet sind, ausgebildet. Dies betrifft bevorzugt die beiden aktiven Bereiche, zwischen denen das frequenzselektive Element und/oder der Tunnelübergang angeordnet sind. Über eine Mehrzahl an Verstärkungsbereichen in einem gemeinsamen Resonator kann die Verstärkung erhöht werden. Ein zum Erreichen der Lasertätigkeit erforderlicher Schwellstrom beziehungsweise eine entsprechende Schwellstromdichte kann hierdurch mit Vorteil reduziert werden. Weiterhin kann bei gleich bleibendem Pumpstrom die im Halbleiterkörper erzeugte Strahlungsleistung erhöht werden.

Alternativ oder ergänzend kann die Reflektivität eines Resonatorspiegels verringert werden, wobei trotz der verringerten Reflektivität aufgrund der erhöhten Verstärkung noch zuverlässig Lasertätigkeit erreicht werden kann. Zweckmäßigerweise wird hierbei die Reflektivität des Auskoppelspiegels verringert, sodass die aus dem Resonator ausgekoppelte Strahlungsleistung ohne maßgebliche Erhöhung des Schwellstroms, gesteigert werden kann.

Ein Pumpstrom für das elektrische Pumpen des Halbleiterbauelements kann durch den ersten Resonatorspiegel und/oder den zweiten Resonatorspiegel fließen. Bevorzugt ist zumindest ein Resonatorspiegel dotiert, sodass der Pumpstrom über den dotierten Resonatorspiegel mit vorteilhaft geringem Widerstand geleitet werden kann.

Der elektrische Widerstand im Resonator beziehungsweise im Halbleiterkörper, insbesondere derjenige eines den Pumpstrom leitenden Resonatorspiegels, wird aufgrund der Mehrzahl an aktiven Bereichen auf diese aktiven Bereiche verteilt. Der vom Pumpstrom im Halbleiterkörper zu überwindende elektrische Widerstand bezogen auf die Anzahl an aktiven Bereichen ist folglich gegenüber einem Halbleiterbauelement mit einer geringeren Zahl von aktiven Bereichen verringert. Die Konversionseffizienz wird so erhöht.

Ein Braggspiegel umfasst bevorzugt eine Mehrzahl von aufeinander gestapelten Schichten, insbesondere Halbleiterschichten, mit unterschiedlichen Brechungsindizes. Diese Schichten sind bevorzugt jeweils als λ/4-Schicht für eine vom Halbleiterbauelement zu emittierende, insbesondere im Resonator zu verstärkende, Strahlung der Wellenlänge λ ausgeführt.

Für einen an der Resonatorbildung beteiligten Braggspiegel können, um das Erreichen der Lasertätigkeit zu gewährleisten, beispielsweise fünfzig oder mehr Schichten erforderlich sein. Der elektrische Widerstand eines Braggspiegels wächst in der Regel mit der Schichtanzahl aufgrund der steigenden Anzahl an Grenzflächen. Daher weist ein Resonatorspiegel, der als Braggspiegel ausgeführt ist, oftmals einen vergleichsweise hohen Widerstand auf. Der Widerstand eines Halbleiterbauelements mit einem monolithisch in den Halbleiterkörper integrierten Resonator-Braggspiegel kann also maßgeblich durch den elektrischen Widerstand dieses, den Pumpstrom leitenden Braggspiegels bestimmt sein. Aufgrund des hohen Widerstands des Spiegels erhöht sich demnach gemäß P=RI² mit der elektrischen Leistung P, dem Strom I und dem Widerstand R auch die erforderliche elektrische Pumpleistung, da am Braggspiegel eine maßgebliche Leistung abfällt. Aufgrund der Mehrzahl von aktiven Bereichen, denen ein gemeinsamer Pumpstrom über den Braggspiegel zugeführt werden kann, wird der Widerstand des Halbleiterbauelements pro aktivem Bereich verringert, wodurch die Konversionseffizienz erhöht werden kann.

In einer weiteren bevorzugten Ausgestaltung weisen der erste Resonatorspiegel und der zweite Resonatorspiegel eine der folgenden Ausgestaltungen auf: gleicher Leitungstyp, verschiedener Leitungstyp. Weisen die Resonatorspiegel den gleichen Leitungstypen auf, so wird zweckmäßigerweise ein für das Halbleiterbauelement vorteilhafter Leitungstyp gewählt. In n-leitenden Halbleitermaterialien ist die Absorption von im Halbleiterkörper erzeugter Strahlung an freien Ladungsträgern in der Regel - verglichen mit p-leitenden Halbleitermaterialien - vorteilhaft gering. Bevorzugt sind daher beide Resonatorspiegel n-leitend und insbesondere als Braggspiegel ausgeführt.

In einer vorteilhaften Weiterbildung ist zwischen einem Resonatorspiegel und dem diesem nächstliegenden aktiven Bereich ein, gegebenenfalls zusätzlicher, Tunnelübergang monolithisch im Halbleiterkörper integriert. Hierdurch wird der Einsatz zweier Resonator-Braggspiegel gleichen Leitungstyps erleichtert, ohne die Stromzufuhr zu den aktiven Bereichen aufgrund eines sich sonst ausbildenden, maßgeblich sperrenden pn-Übergangs maßgeblich zu behindern.

Gegenüber Resonator-Braggspiegeln gleichen Leitungstyps ist ein Halbleiterkörper mit monolithisch integrierten Resonator-Braggspiegeln verschiedenen Leitungstyps vereinfacht und insbesondere zum Großteil standardgemäß fertigbar.

In einer weiteren bevorzugten Ausgestaltung umfassen zwei aktive Bereiche eine Quantentopfstruktur. Eine Ein- oder Mehrfach-Quantentopfstruktur zeichnet sich durch besonders hohe interne Quanteneffizienz bei der Strahlungserzeugung im jeweiligen aktiven Bereich aus. Hierbei beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

In einer weiteren bevorzugten Ausgestaltung ist der Halbleiterkörper derart ausgebildet, dass das sich im Betrieb des Halbleiterbauelements innerhalb des Resonators ausbildende, insbesondere im Halbleiterkörper zu verstärkende, Strahlungsfeld ein Intensitätsminimum (Intensitätsknoten) innerhalb des Tunnelübergangs, der die zwei aktiven Bereiche des Halbleiterkörpers, insbesondere seriell, elektrisch leitend verbindet, aufweist. Dies betrifft bevorzugt eine zu verstärkende, vorzugsweise vorgegebene, Mode des Stehwellenfeldes.

Alternativ oder zusätzlich kann der Halbleiterkörper für den einem Braggspiegel, wie oben beschrieben, nachgeschalteten Tunnelübergang entsprechend ausgebildet sein. Auch in diesem, gegebenenfalls zusätzlichen, Tunnelübergang kann somit ein Intensitätsminimum des Stehwellenfeldes angeordnet sein.

Aufgrund der mittels des frequenzselektiven Elements verminderbaren Strahlungsintensität im Bereich des Tunnelübergangs kann im Tunnelübergang nur eine vergleichsweise geringe Strahlungsleistung absorbiert werden. Auch bei der Ausbildung des Tunnelübergangs im Halbleiterkörper leicht außerhalb eines Intensitätsminimums des Stehwellenfeldes kann die im Tunnelübergang absorbierbare Strahlungsleistung hierdurch vereinfacht in vertretbarem Rahmen gehalten werden, ohne dass die Effizienz oder die Lasereigenschaften des Halbleiterbauelements wesentlich beeinträchtigt sind. So kann zum Beispiel der Schwellstrom trotz eines die aktiven Bereiche elektrisch aneinander koppelnden, absorbierenden Tunnelübergangs vereinfacht vergleichsweise gering gehalten werden.

Bei der Anordnung des Tunnelübergangs beziehungsweise der Herstellung des Halbleiterkörpers, der bevorzugt epitaktisch auf einem Aufwachssubstrat gewachsen ist, ist somit aufgrund der Intensitätsmodulation mittels des frequenzselektiven Elements die Fertigungstoleranz erhöht, ohne dass die Effizienz maßgeblich gemindert ist. Eine Abweichung von der Anordnung des Tunnelübergangs um einen Intensitätsknoten führt insbesondere nur zu einer maßvollen Erhöhung der absorbierten Strahlungsleistung.

Das frequenzselektive Element umfasst einen Braggspiegel und einen weiteren Braggspiegel. Der Halbleiterkörper kann also insbesondere zusätzlich zu einem (den) Resonator-Braggspiegel(n) einen weiteren Braggspiegel umfassen, der bevorzugt als im Halbleiterkörper monolithisch integrierter Braggspiegel ausgeführt ist. Die Braggspiegel des frequenzselektiven Elements sind zwischen zwei aktiven Bereichen des Halbleiterkörpers angeordnet.

Das frequenzselektive Element ist frei von einem aktiven Bereich, so dass insbesondere zwischen den Braggspiegeln des frequenzselektiven Elements kein aktiver Bereich angeordnet ist.

Über das frequenzselektive Element werden, insbesondere mittels Reflexion an den Braggspiegeln, zusätzliche Phasenbedingungen für das Strahlungsfeld innerhalb des Resonators geschaffen. Die Intensität des Stehwellenfeldes im Resonator kann zwischen den Braggspiegeln des frequenzselektiven Elements vereinfacht verringert werden. Insbesondere betrifft dies eine Absenkung der einhüllenden Kurve der Intensitätsverteilung des Stehwellenfeldes im Halbleiterkörper innerhalb des frequenzselektiven Elements gegenüber einem Halbleiterkörper ohne ein frequenzselektives Element.

Die einhüllende Kurve der Intensitätsverteilung des Strahlungsfeldes kann also über das frequenzselektive Element gezielt geformt und modifiziert werden. Die einhüllende Kurve der Intensitätsverteilung, insbesondere einer im Resonator zu verstärkenden, zum Beispiel longitudinalen, Mode, kann derart geformt werden, dass sie ein lokales Minimum zwischen den aktiven Bereichen - insbesondere denjenigen, zwischen denen das frequenzselektive Element angeordnet ist -, innerhalb des frequenzselektiven Elements, zwischen den Braggspiegeln des Elements und/oder im Bereich des Tunnelübergangs, aufweist.

Alternativ oder zusätzlich kann ein lokales Maximum der einhüllenden Kurve mittels des frequenzselektiven Elements gezielt, zum Beispiel nach außerhalb des Bereichs zwischen zwei aktiven Bereichen, verschoben werden.

Alternativ oder zusätzlich kann das frequenzselektive Element zur, insbesondere longitudinalen, Modenselektion ausgebildet sein. Hierdurch kann die Auswahl einer vorgegebenen, im Resonator zu verstärkenden Mode vereinfacht werden. Das frequenzselektive Element erhöht hierbei bevorzugt die Verluste für nicht im Resonator zu verstärkende Moden. Ein longitudinal monomodiger Betrieb des Halbleiterelements ist so vereinfacht erreichbar.

Das frequenzselektive Element ist vorzugsweise derart ausgebildet, dass die Ausbildung eines Subresonators, das heißt eines separaten Resonators für einen aktiven Bereich eines Paars von aktiven Bereichen, im Halbleiterbauelement vermieden wird. Hierzu ist (sind) der (die) Braggspiegel des frequenzselektiven Elements zweckmäßigerweise für die im Resonator zu verstärkende Strahlung der Wellenlänge λ mit derart geringen Reflektivitäten ausgebildet, dass ein Anschwingen von Moden, die nicht dem gemeinsamen Resonator angehören, vermieden wird.

Eine Reflektivität von 95% oder weniger, bevorzugt 90% oder weniger, besonders bevorzugt 80% oder weniger, ist hierfür besonders geeignet. Die Reflektivität des Braggspiegels und/oder des weiteren Braggspiegels ist weiterhin bevorzugt größer als 30%, besonders bevorzugt größer als 40%. Derartige Reflektivitäten sind für die Intensitätsmodulation besonders geeignet. Je geringer die Reflektivität der einzelnen Spiegel für die erzeugte Strahlung ist, desto geringer ist auch die Gefahr des Anschwingens von Subresonatormoden. Je größer die Reflektivität ist, desto besser kann jedoch die Intensitätsverteilung beeinflusst werden.

Der Tunnelübergang, der die beiden aktiven Bereiche elektrisch leitend verbindet, ist zwischen den beiden Braggspiegeln des frequenzselektiven Elements angeordnet. Bevorzugt grenzen Tunnel-Halbleiterschichten des Tunnelübergangs jeweils an die Schichten des entsprechenden Braggspiegels an.

Weiterhin weisen die Braggspiegel des frequenzselektiven Elements bevorzugt unterschiedliche Leitungstypen auf. Das frequenzselektive Element kann insbesondere monolithisch im Halbleiterkörper integriert sein. Strukturelle Modifikationen am frequenzselektiven Element sind nach dem Aufwachsen von Schichten für Braggspiegel des frequenzselektiven Elements für die Frequenzselektion mit Vorteil nicht erforderlich.

In einer weiteren bevorzugten Ausgestaltung ist zwischen zwei aktiven Bereichen, bevorzugt im frequenzselektiven Element integriert, besonders bevorzugt in einem Braggspiegel des frequenzselektiven Elements integriert, eine Stromblende ausgebildet. Der Stromfluss im Halbleiterkörper kann mittels eines elektrisch isolierenden Stromsperrbereichs der Stromblende lateral in Richtung einer elektrisch leitfähigen, stromführenden Apertur der Stromblende geführt und in vertikaler Richtung durch diese Apertur geleitet werden. Mittels der Stromblende wird der Stromfluss in lateraler Richtung konzentriert und insbesondere der Strompfad eingeschnürt. Der Ladungsträgerfluss zwischen den aktiven Bereichen kann über die Stromblende in lateraler Richtung eingeschnürt werden, wodurch der Stromaufweitung zwischen den aktiven Bereichen vorgebeugt wird. Die Stromdichte im Halbleiterkörper kann mittels der Stromblende durch Einschnürung erhöht werden, wodurch eine zum Erreichen der Lasertätigkeit erforderliche Schwellstromdichte vereinfacht erreicht werden kann.

Bevorzugt ist die Stromblende in einem p-leitenden Halbleiterbereich des Halbleiterkörpers, zum Beispiel in einem p-leitenden Braggspiegel des frequenzselektiven Elements, integriert. Bei herkömmlichen Halbleiterlaserbauelementen ist oftmals innerhalb eines p-leitenden Halbleiterbereichs, insbesondere einem p-leitenden Resonator-Braggspiegel, eine Stromblende ausgebildet. Die Integration einer zusätzlichen Stromblende in einem Halbleiterbereich zwischen den aktiven Bereichen, insbesondere einem p-leitenden Braggspiegel des frequenzselektiven Elements, kann so vereinfacht in der gleichen Materialumgebung, das heißt in Schichten gleicher Zusammensetzung und/oder Dotierung, wie die ohnehin im Halbleiterkörper vorgesehenen Stromblende realisiert werden. Da eine Stromblende oftmals als Oxidblende mittels lateraler Oxidation einer Halbleiterschicht ausgebildet wird, können so vereinfacht zwei Stromblenden mit einer gleichgroßen, stromleitenden Apertur ausgebildet werden.

In einer weiteren bevorzugten Ausgestaltung ist der Halbleiterkörper derart ausgebildet, dass ein aktiver Bereich gezielt derart außerhalb eines Intensitätsmaximums des Strahlungsfeldes im Resonator angeordnet ist, dass dieses Intensitätsmaximum innerhalb eines n-leitenden Halbleiterbereichs des Halbleiterkörpers, der bevorzugt an den aktiven Bereich angrenzt, liegt oder in dessen Richtung verschoben ist. Dies kann durch geeignete Ausbildung des Halbleiterkörpers erreicht werden. Das Intensitätsmaximum ist vorzugsweise das dem aktiven Bereich nächstliegende Intensitätsmaximum, insbesondere einer in den aktiven Bereichen zu verstärkenden Mode.

In einer weiteren bevorzugten Ausgestaltung enthält der Halbleiterkörper, insbesondere der Tunnelübergang, die aktiven Bereiche und/oder das frequenzselektive Element, ein III-V-Halbleitermaterial, insbesondere ein Material aus den III-V-Halbleitermaterialsystemen Inₓ Ga_{y} Al_{1-x-y} P, Inₓ Ga_{y} Al_{1-x-y} N oder Inₓ Ga_{y} Al_{1-x-y} As, jeweils mit 0≤x≤1, 0≤y≤1 und x+y≤1 und/oder ein Material aus den Halbleitermaterialsystemen InGaAsN, InGaAsSb, InGaAsSbN oder Inₓ Ga₁₋ₓ As_{y} P_{1-y} mit 0≤x≤1, 0≤y≤1, wobei für die angegebenen Parameter x und y bevorzugt jeweils x≠0 und/oder y≠0 gilt. Weiterhin ist bevorzugt x≠1 und/oder y≠1. III-V-Halbleitermaterialien können sich durch besonders hohe Quanteneffizienzen bei der Strahlungserzeugung und vereinfachte Herstellbarkeit eines Halbleiterkörpers für das Halbleiterbauelement auszeichnen. Mit den genannten Materialsystemen kann Strahlung in verschiedenen Spektralbereichen besonders effizient erzeugt werden. Hierbei ist Inₓ Ga_{y} Al_{1-x-y} N für ultraviolette Strahlung, über blaue bis zu grüner Strahlung, Inₓ Ga_{y} Al_{1-x-y} P für gelbe bis rote Strahlung und Inₓ Ga_{y} Al_{1-x-y} As für infrarote Strahlung besonders geeignet.

In einer Ausführungsform der Messanordnung umfasst die Detektionseinrichtung wenigstens ein erstes Fotohalbleiterelement. Beispielsweise ist das wenigstens eine erste Fotohalbleiterelement als Fotodiode oder als Fototransistor oder als Fotowiderstand ausgeführt. Bei einem Fotohalbleiterelement werden durch das Auftreffen von energietragenden Strahlungsteilchen, zum Beispiel von Photonen, Elektronen an einem PN-Übergang des Fotohalbleiterelements auf ein höheres Energieniveau gehoben. Durch derart erzeugte freie Ladungsträger wird ein Stromfluss beziehungsweise ein veränderter Stromfluss durch das Fotohalbleiterbauelement möglich, welcher als Detektionsergebnis an die Auswerteschaltung weitergegeben werden kann.

Bei einer Fotodiode, die üblicherweise in Sperrrichtung gepolt ist, können somit auftreffende Photonen dadurch detektiert werden, dass sich ein Stromfluss durch die Fotodiode einstellt, welcher beispielsweise in der Detektionseinrichtung messbar ist und in der Auswerteschaltung als Detektionsergebnis verarbeitet wird.

Bei einem Fototransistor erfolgt ein Durchschalten der gesteuerten Strecke des Transistors in Abhängigkeit des Auftreffens von Lichtteilchen, wobei die Lichtteilchen in diesem Ausführungsbeispiel von der reflektierten Strahlung umfasst sind. Somit kann ein Schaltvorgang des Fototransistors für die Detektion der reflektierten Strahlung als Detektionsergebnis ausgewertet werden.

Bei einem Fotowiderstand verändert sich mit dem Auftreffen von Lichtteilchen der elektrische Widerstand des Bauelements. Diese Veränderung kann beispielsweise durch Beaufschlagung des Fotowiderstands mit einer Spannung oder einem Strom detektiert werden.

Die Detektionseinrichtung kann auch mehrere Fotohalbleiterbauelemente umfassen, wie beispielsweise eine Vielzahl von Fotodioden oder eine Vielzahl von Fototransistoren oder auch eine Kombination von verschiedenen Fotohalbleiterbauelementen.

In einer weiteren Ausführungsform der Messanordnung umfasst diese eine zweite Detektionseinrichtung zur Detektion reflektierter Strahlung, welche mit Auswerteschaltung zur Steuerung und Verarbeitung des Detektionsergebnisses gekoppelt ist. Durch die zweite Detektionseinrichtung können beispielsweise Reflexionen von Strahlung an einem Objekt, welche diffus oder gerichtet erfolgen, auch an mehreren Orten der Messanordnung detektiert werden. Zudem kann die Detektionssicherheit erhöht werden, da eine Detektion reflektierter Strahlung auch dann möglich ist, wenn eine der beiden Detektionseinrichtungen beispielsweise optisch verdeckt ist.

In einer weiteren Ausführungsform der Messanordnung kann diese auch eine größere Anzahl von Detektionseinrichtungen aufweisen.

In einer Ausführungsform der Messanordnung umfasst die Strahlungseinrichtung eine Mehrzahl von oberflächenemittierenden Halbleiterbauelementen entsprechend dem ersten oberflächenemittierenden Halbleiterelement. Beispielsweise sind dabei die Mehrzahl von oberflächenemittierenden Halbleiterbauelementen als eindimensionales oder zweidimensionales Strahlungsfeld angeordnet.

Bei einem eindimensionalen Strahlungsfeld können die mehreren oberflächenemittierenden Halbleiterbauelemente entlang einer Linie oder einer Kurve angeordnet sind. Beispielsweise weisen die mehreren Halbleiterbauelemente unterschiedliche Abstrahlwinkel auf, sodass durch die mehreren Halbleiterbauelemente Messungen in einem aufgespreizten Bereich durchgeführt werden können. In einer Ausführungsform sind die oberflächenemittierenden Halbleiterbauelemente zur Emission von Strahlung verschiedener Wellenlänge ausgelegt. Somit kann eine Strahlungsemission von den mehreren Halbleiterbauelementen gleichzeitig erfolgen, wobei die Strahlungen verschiedener Wellenlänge beispielsweise von verschiedenen Detektoren beziehungsweise Detektionseinrichtungen erfasst werden, welche für die unterschiedlichen Wellenlängen eingerichtet sind.

Bei einem zweidimensionalen Strahlungsfeld sind beispielsweise die strahlungsemittierenden Oberflächen der Halbleiterbauelemente zu einer einer ebenen oder gekrümmten Fläche angeordnet. Ähnlich wie bei dem eindimensionalen Strahlungsfeld können die Halbleiterbauelemente unterschiedliche Strahlungswinkel zueinander aufweisen. Beispielsweise kann so eine Oberflächenstruktur eines Objekts vermessen werden.

Für die Halbleiterbauelemente in einem eindimensionalen oder zweidimensionalen Strahlungsfeld kann eine Strahlungsemission der oberflächenemittierenden Halbleiterbauelemente einzeln steuerbar sein. Beispielsweise werden die einzelnen Halbleiterbauelemente des Strahlungsfelds jeweils nacheinander zur Emission eines Strahlungspulses angesteuert. Eine Detektion einer reflektierten Strahlung kann über eine einzige Detektionseinrichtung oder über eine Mehrzahl von Detektionseinrichtungen erfolgen. Ein zeitlicher Abstand zwischen emittierten Strahlungspulsen entspricht dabei bevorzugt in etwa einer Zeit, die aus dem Weg zwischen der Messanordnung und dem zu erwartenden reflektierenden Objekt abgeleitet ist, um die Detektion eines reflektierten Strahlungspulses eindeutig jeweils einem der oberflächenemittierenden Halbleiterbauelemente zuordnen zu können.

In einer weiteren Ausführungsform der Messanordnung erfolgt eine Strahlungsemission der Mehrzahl von oberflächenemittierenden Halbleiterbauelementen gebündelt. Beispielsweise werden mehrere Halbleiterbauelemente vorgesehen, die synchron zur Strahlungsemission angesteuert werden, um eine Strahlungsleistung der Strahlungseinrichtung zu erhöhen, wobei eine Bündelung der einzelnen Strahlungen beispielsweise über eine Linse erfolgen kann.

In einer weiteren Ausführungsform der Messanordnung ist wenigstens ein optisches Element zur Strahlformung und/oder zur Strahlführung der vom Halbleiterbauelement beziehungsweise von der Strahlungseinrichtung emittierten Strahlung vorgesehen. Das optische Element kann wenigstens eines der folgenden Elemente aufweisen: einen Spiegel, einen optischen Spalt, ein optisches Gitter, eine Linse, eine Lichtleitfaser.

Über einen Spiegel kann eine von der Strahlungseinrichtung emittierte Strahlung in ihrer Richtung umgelenkt werden. Der Spiegel kann dabei fest angebracht sein, um einen vorgegebenen, festen Abstrahlwinkel zu erreichen. Alternativ kann der Spiegel auch beweglich angebracht sein, um eine räumliche oder linienförmige Ablenkung der emittierten Strahlung zu erreichen.

Durch einen optischen Spalt oder durch ein optisches Gitter kann eine diffraktive Verformung der Strahlung der Strahlungseinrichtung erfolgen. Dies kann eine aufweitende oder bündelnde Verformung der Strahlung bewirken. Über eine Linse kann beispielsweise ein kollimierter, das heißt gebündelter Strahl erzeugt werden.

Über eine Lichtleitfaser kann die von der Strahlungseinrichtung emittierte Strahlung zu einem anderen Ort für die eigentliche Strahlungsemission geführt werden. Beispielsweise wird so ermöglicht, dass die eigentliche Strahlungserzeugung unabhängig vom gewünschten Ausstrahlungsort der emittierten Strahlung vorgesehen werden kann, wie zum Beispiel in einem gesonderten geschützten Bereich.

In einer Ausführungsform eines Messsystems umfasst dieses eine Messanordnung nach einem der beschriebenen Ausführungsbeispiele und ist eingerichtet zur Entfernungsmessung. Alternativ oder zusätzlich ist ein Messsystem mit einer Messanordnung nach einem der beschriebenen Ausführungsbeispiele auch zur Geschwindigkeitsmessung eingerichtet. Beispielsweise können mit der Messanordnung Entfernungen beziehungsweise Abstände zu einem Objekt zu unterschiedlichen Zeitpunkten gemessen werden. Aus den gemessenen Abständen und dem Zeitabstand zwischen den Messungen kann somit eine Geschwindigkeit beziehungsweise Relativgeschwindigkeit des gemessenen Objekts zur Messanordnung beziehungsweise zum Messsystem ermittelt werden.

In einer Ausführungsform eines Messsystems umfasst dieses eine Messanordnung nach einem der beschriebenen Ausführungsbeispiele und ist als Abstandsregeltempomat ausgebildet. Ein Abstandsregeltempomat, englisch adaptive cruise control, ACC kann beispielsweise in einem Fahrzeug eingesetzt werden, um automatisch die Geschwindigkeit des Fahrzeugs in Abhängigkeit eines Abstands zu einem vorausfahrenden Fahrzeug und zu einer Geschwindigkeit des vorausfahrenden Fahrzeugs anzupassen.

Weitere Merkmale, vorteilhafte Ausgestaltungen und Zweckmäßigkeiten der Erfindung ergeben sich aus der folgenden Beschreibung der Ausführungsbeispiele in Verbindung mit den Figuren. Gleiche, gleichartige und gleich wirkende Elemente sind in den Figuren mit gleichen Bezugszeichen versehen.

Dabei zeigen:
- Figur 1: ein erstes Ausführungsbeispiel einer Messanordnung,
- Figur 2: ein erstes Ausführungsbeispiel eines oberflächenemittierenden Halbleiterbauelements,
- Figur 3: ein zweites Ausführungsbeispiel eines oberflächenemittierenden Halbleiterbauelements,
- Figur 4: ein zweites Ausführungsbeispiel einer Messanordnung,
- Figur 5: ein erstes Ausführungsbeispiel einer Strahlungseinrichtung,
- Figur 6: ein zweites Ausführungsbeispiel einer Strahlungseinrichtung,
- Figur 7: ein drittes Ausführungsbeispiel einer Strahlungseinrichtung,
- Figur 8: ein Ausführungsbeispiel eines oberflächenemittierenden Halbleiterbauelements mit einem Spiegel,
- Figur 9: ein Ausführungsbeispiel eines oberflächenemittierenden Halbleiterbauelements mit einem Gitter,
- Figur 10: ein drittes Ausführungsbeispiel einer Messanordnung und
- Figur 11: ein Ausführungsbeispiel eines Abstandsregeltempomaten.

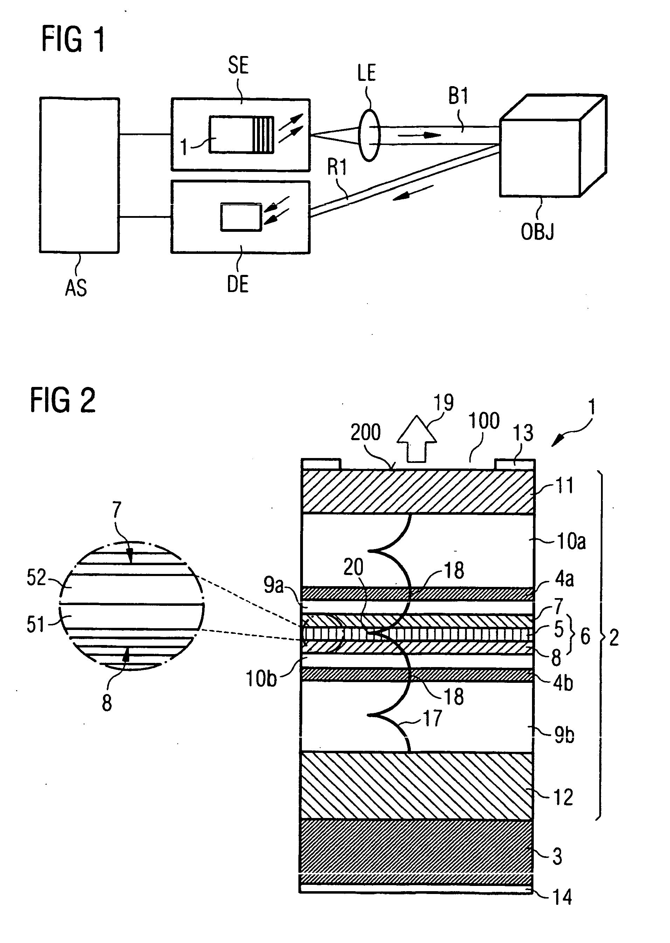

Figur 1 zeigt ein Ausführungsbeispiel einer Messanordnung mit einer Auswerteschaltung AS, einer Strahlungseinrichtung SE und einer Detektionseinrichtung DE. Die Auswerteschaltung AS ist mit der Strahlungseinrichtung SE und der Detektionseinrichtung DE zur Steuerung der Einrichtungen SE, DE sowie zur Verarbeitung eines Detektionsergebnisses der Detektionseinrichtung DE gekoppelt. Die Strahlungseinrichtung SE weist wenigstens ein erstes oberflächenemittierendes Halbleiterbauelement 1 mit einer vertikalen Emissionsrichtung auf, welches mehrere in vertikaler Richtung voneinander beabstandet angeordnete aktive Bereiche umfasst. Von der Strahlungseinrichtung SE geht im Betrieb eine Strahlung, beispielsweise eine Laserstrahlung aus, die durch eine Linse LE zu einem Strahl B1 gebündelt wird.

In Figur 1 ist ferner ein Objekt OBJ dargestellt, welches jedoch nicht Teil der Messanordnung ist. Die Strahlung B1 trifft im Betrieb auf das Objekt OBJ und wird dort als Strahlung R1 reflektiert. Die reflektierte Strahlung R1 trifft auf die Detektionseinrichtung DE, welche beispielsweise ein Fotohalbleiterbauelement zur Detektion der reflektierten Strahlung umfasst.

Die Emission der Strahlung B1 erfolgt jedoch üblicherweise nicht dauerhaft. Vielmehr ist die Auswerteschaltung AS dazu eingerichtet, eine Strahlungsemission des ersten oberflächenemittierenden Halbleiterbauelements 1 beziehungsweise der Strahlungseinrichtung SE pulsförmig zu steuern.

In der Detektionseinrichtung DE wird die detektierte reflektierte Strahlung R1 beispielsweise in einen Strom oder in Ladung umgesetzt, welche in der Auswerteschaltung AS als Detektionsergebnis ausgewertet werden. Die Auswerteschaltung AS kann beispielsweise einen Zeitabstand zwischen der Emission des Strahlungspulses B1 und der Detektion der reflektierten Strahlung R1 ermitteln. Über die Ausbreitungsgeschwindigkeit der Strahlung B1, R1, welche üblicherweise nahezu der Lichtgeschwindigkeit entspricht, kann aus dem ermittelten Zeitabstand ein räumlicher Abstand zwischen der Messanordnung und dem Messobjekt OBJ ermittelt werden. Damit eignet sich die Messanordnung insbesondere zur Entfernungsmessung.

Jedoch können auch mittels Aussendung einer Pulsfolge von Strahlungspulsen Geschwindigkeiten beziehungsweise Relativgeschwindigkeiten zwischen der Messanordnung und dem Messobjekt anhand einer sich in einer bestimmten Zeit verändernden Entfernung bestimmt werden. Ferner kann auch eine Frequenzverschiebung der reflektierten Strahlung R1 nach dem Dopplerprinzip ausgewertet werden. Es ist auch möglich, die Laserstrahlung zu modulieren, um derart eine Entfernung oder eine Geschwindigkeit zu messen.

Figur 2 zeigt eine schematische Schnittansicht eines Ausführungsbeispiels eines strahlungsemittierenden Halbleiterbauelements 1, das in der Strahlungseinrichtung SE von Figur 1 verwendet werden kann. Das strahlungsemittierende Halbleiterbauelement 1 ist als elektrisch gepumptes Halbleiterlaserbauelement, insbesondere als VCSEL mit einem internen Resonator, ausgeführt. Das Halbleiterbauelement 1 umfasst einen Halbleiterkörper 2, der auf einem Substrat 3, das den Halbleiterkörper mit Vorteil mechanisch stabilisiert, angeordnet ist. Der Halbleiterkörper 2 ist bevorzugt monolithisch integriert ausgeführt und besonders bevorzugt auf dem Substrat 3, das dann das Aufwachssubstrat umfasst oder aus diesem ausgebildet ist, epitaktisch gewachsen.

Der Halbleiterkörper 2 umfasst zwei aktive Bereiche 4a und 4b, die zur elektrolumineszenten Strahlungserzeugung geeignet sind. Diese aktiven Bereiche sind voneinander beabstandet und im Halbleiterkörper zueinander benachbart angeordnet. Über einen zwischen diesen aktiven Bereichen im Halbleiterkörper angeordneten und ausgebildeten Tunnelübergang 5 sind die aktiven Bereiche 4a und 4b seriell elektrisch leitend verbunden. Der Tunnelübergang 5 ist in ein frequenzselektives Element 6, das zwischen den aktiven Bereichen 4a und 4b angeordnet ist, eingebettet und insbesondere vom frequenzselektiven Element umgeben.

Das frequenzselektive Element 6 umfasst einen ersten Braggspiegel 7 und einen zweiten Braggspiegel 8, die zwischen den aktiven Bereichen 4a und 4b im Halbleiterkörper 2 angeordnet und bevorzugt monolithisch im Halbleiterkörper integriert sind. Der Tunnelübergang 5 ist insbesondere zwischen den Braggspiegeln 7 und 8 des frequenzselektiven Elements angeordnet und ebenfalls bevorzugt monolithisch in den Halbleiterkörper integriert durchgeführt. Innerhalb des frequenzselektiven Elements und insbesondere zwischen den Braggspiegeln 7 und 8 des frequenzselektiven Elements 6 ist kein aktiver Bereich angeordnet.

Die aktiven Bereiche 4a und 4b sind jeweils zwischen zwei Halbleiterbereichen - den Halbleiterbereichen 9a und 10a im Falle des aktiven Bereichs 4a beziehungsweise den Halbleiterbereichen 9b und 10b im Falle des aktiven Bereichs 4b - angeordnet, wobei die einen aktiven Bereich umgebenden Halbleiterbereiche bevorzugt, insbesondere jeweils, verschiedene Leitungstypen - n-leitend oder p-leitend - aufweisen. Hierzu sind die Halbleiterbereiche zweckmäßigerweise entsprechend dotiert.

Bevorzugt weisen die auf der entsprechenden, insbesondere der gleichen, Seite des jeweiligen aktiven Bereichs angeordneten Halbleiterbereiche den gleichen Leitungstyp auf. Insbesondere weisen die Halbleiterbereiche 9a und 9b, zum Beispiel n-leitend, beziehungsweise die Halbleiterbereiche 10a und 10b, zum Beispiel p-leitend, vorzugsweise jeweils die gleichen Leitungstypen auf.

Ein Resonator des Halbleiterbauelements 1 ist mittels eines ersten Resonator-Endspiegels 11 und eines zweiten Resonator-Endspiegels 12 gebildet, zwischen denen die beiden aktiven Bereiche 4a und 4b angeordnet sind und die den Resonator bevorzugt begrenzen. Die Resonator-Endspiegel sind vorzugsweise auf den aktiven Bereichen aufgebracht, wodurch insbesondere ein interner Resonator gebildet ist.

Der erste Resonator-Endspiegel 11 und/oder der zweite Resonator-Endspiegel 12 ist bevorzugt als monolithisch in dem Halbleiterkörper 2 integrierter Resonator-Braggspiegel ausgebildet und besonders bevorzugt ist der erste Resonator-Endspiegel und/oder der zweite Resonator-Endspiegel dotiert. Der jeweilige dotierte Resonator-Braggspiegel weist bevorzugt den gleichen Leitungstyp auf, wie ein zwischen dem jeweiligen Resonator-Braggspiegel und dem nächstliegenden aktiven Bereich angeordneter Halbleiterbereich. Der erste Resonator-Endspiegel 11 ist demnach bevorzugt p-leitend (entsprechend dem Halbleiterbereich 10a) und der zweite Resonator-Endspiegel 12 ist bevorzugt n-leitend (entsprechend dem Halbleiterbereich 9b) ausgeführt.

Ferner ist der erste Braggspiegel 7 und/oder der zweite Braggspiegel 8 des frequenzselektiven Elements 6 bevorzugt dotiert. Der erste Braggspiegel 7 weist bevorzugt den gleichen Leitungstypen auf wie der, insbesondere auf der dem Tunnelübergang 5 abgewandten Seite des Braggspiegels 7 an den Braggspiegel angrenzende, Halbleiterbereich 9a. Entsprechendes gilt für den zweiten Braggspiegel 8 des frequenzselektiven Elements 6 bezüglich des, insbesondere zwischen den beiden aktiven Bereichen angeordneten, Halbleiterbereichs 10b. Der erste Braggspiegel 7 ist demnach bevorzugt n-leitend und der zweite Braggspiegel 8 bevorzugt p-leitend ausgeführt.

Die aktiven Bereiche 4a und 4b sind über das zwischen den aktiven Bereichen angeordnete frequenzselektive Element 6 und den Tunnelübergang 5 elektrisch leitend miteinander und ferner mit einem ersten Kontakt 13 sowie einem zweiten Kontakt 14 des Halbleiterbauelements 1 verbunden. Über die Kontakte 13 und 14 können im Betrieb des Halbleiterbauelements Ladungsträger in den Halbleiterkörper 2 injiziert werden, die in den aktiven Bereichen 4a und 4b unter Strahlungserzeugung rekombinieren können.

Der erste Kontakt 13, zum Beispiel eine Kontaktmetallisierung, ist bevorzugt auf der dem Substrat 3 abgewandten Seite des Halbleiterkörpers 2 angeordnet und, falls, wie bei einem dargestellten Top-Emitter, eine Emissionsoberfläche 200 des Halbleiterkörpers 2 auf der dem Substrat 3 abgewandten Seite des Halbleiterkörpers angeordnet ist, ist der erste Kontakt zweckmäßigerweise für den Strahlungsdurchtritt ausgespart und zum Beispiel als Ringkontakt ausgeführt. Der zweite Kontakt 14, zum Beispiel eine Kontaktmetallisierung, ist bevorzugt auf der dem Halbleiterkörper 2 abgewandten Seite des Substrats 3 angeordnet. Für die Stromdurchleitung ist das Substrat 3 bevorzugt elektrisch leitend ausgeführt, zum Beispiel durch entsprechende Dotierung.

Eine Apertur 100 des Ringkontakts für den Strahlungsdurchtritt kann in Aufsicht auf die Emissionsoberfläche 200 des Halbleiterkörpers 2 kreisartig oder ellipsenartig ausgeführt sein. Eine ellipsenartige Ausführung ist zur Beeinflussung der Polarisation für eine aus dem Halbleiterkörper 2 austretende Strahlung 19, zum Beispiel infrarote Strahlung, besonders geeignet.

Ladungsträger, die in einem der aktiven Bereiche strahlend rekombinieren, können nach dem Tunneln durch den Tunnelübergang 5 in den anderen aktiven Bereich gelangen. Der Tunnelübergang 5 ist bevorzugt derart ausgebildet, dass Ladungsträger nach der Rekombination in einem aktiven Bereich von dem Valenzband dieses aktiven Bereichs in das Leitungsband des anderen aktiven Bereichs tunneln und in diesem nochmals strahlend rekombinieren. Die Konversionseffizienz des Halbleiterbauelements bei der Umwandlung von elektrischer Leistung in Strahlungsleistung wird so vorteilhaft erhöht, da ein Ladungsträger mehrfach, d. h. in einer Mehrzahl von aktiven Bereichen, zur Strahlungserzeugung genutzt werden kann.

In dem Resonator baut sich mittels Reflexion an den Resonator-Endspiegeln ein Strahlungsfeld stehender Wellen (Stehwellenfeld) auf. Dieses Strahlungsfeld, insbesondere eine Mode des Feldes, kann durch stimulierte Emission in den aktiven Bereichen 4a und 4b verstärkt werden. Die verstärkte kohärente Laserstrahlung 19 kann über einen als Auskoppelspiegel dienenden Resonator-Endspiegel, vorliegend den Resonator-Endspiegel 11, aus dem Halbleiterkörper 2 des Halbleiterbauelements 1 in vertikaler Richtung, d. h. senkrecht zu einer lateralen Hauptfläche der aktiven Bereiche, die bevorzugt, parallel zueinander angeordnet sind, aus dem Resonator auskoppeln.

Der Halbleiterkörper 2 des Halbleiterbauelements 1 basiert bevorzugt auf (In, A1)GaAs, besonders bevorzugt auf (A1)GaAs. Derartige Materialien sind zur effizienten Strahlungserzeugung, insbesondere infraroter Strahlung, besonders geeignet. Infrarote Strahlung eignet sich beispielsweise zum Einsatz in laserbasierten Messsystemen, wofür das Halbleiterbauelement bevorzugt vorgesehen ist, sowie zur Datenübertragung.

Die Resonator-Endspiegel 11 und 12 weisen bevorzugt eine hohe Reflektivität, zum Beispiel von 97% oder größer, insbesondere 99% oder größer, etwa 99,9%, für in den aktiven Bereichen zu verstärkende Strahlung der Wellenlänge λ auf. Die Reflektivität eines als Auskoppelspiegel dienenden Resonatorspiegels ist bevorzugt geringer als die des weiteren Resonatorspiegels, vorliegend des zweiten Resonator-Endspiegels 12.

Ein Braggspiegel des Halbleiterbauelements - der erste Resonator-Braggspiegel 11, der zweite Resonator-Braggspiegel 12, der erste Braggspiegel 7 des frequenzselektiven Elements und/oder der zweite Braggspiegel 8 des frequenzselektiven Elements 6 - weist bevorzugt eine Vielzahl von Halbleiterschichten, beispielsweise 55 oder mehr Halbleiterschichten für einen Resonator-Endspiegel, mit unterschiedlichen Brechungsindices auf. Diese basieren vorzugsweise jeweils auf (Al)GaAs. Für das Erzielen einer vorgegebenen Reflektivität, insbesondere der Resonator-Endspiegel 11 beziehungsweise 12, die für das Erreichen der Lasertätigkeit ausreicht, zum Beispiel von 99,8% oder größer, ist oftmals eine derart hohe Schichtanzahl nötig. Die Halbleiterschichten eines Braggspiegels des Halbleiterbauelements sind weiterhin bevorzugt jeweils als λ/4-Schichten für in den aktiven Bereichen 4a und 4b zu verstärkende Strahlung der Wellenlänge λ ausgeführt.

Um die Schichtanzahl in einem Braggspiegel bei gleich bleibender Reflektivität zu verringern, werden bevorzugt Materialien mit vorteilhaft hohem Brechungsindexunterschied, etwa AlAs und GaAs, für die verschiedenen Halbleiterschichten des Braggspiegels eingesetzt. Der elektrische Widerstand des Braggspiegels kann so aufgrund der vergleichsweise geringen Schichtanzahl vorteilhaft gering gehalten werden. Der Braggspiegel kann Halbleiterschichtenpaare mit Einzelschichten unterschiedlicher Brechungsindices umfassen, die derart alternierend angeordnet sind, dass auf eine hochbrechende Schicht eine niedrigbrechende Schicht folgt. Alternativ oder ergänzend können Spiegelstrukturen eingesetzt werden, bei denen eine oder eine Mehrzahl von λ/4-Schichten einen Material-Gradienten, beispielsweise einen Gradienten im Al-Gehalt, aufweisen.

Der Pumpstrom für das elektrische Pumpen des Halbleiterbauelements wird über die Kontakte 13, 14, die Resonator-Endspiegel 11 und 12 sowie vorzugsweise das Substrat 3 in den Halbleiterkörper injiziert.

Aufgrund der Vielzahl von Schichten tragen Resonator-Braggspiegel 11 und 12 in hohem Maße zum gesamten elektrischen Widerstand des Halbleiterkörpers 2 bei. Da der Widerstand dieser Braggspiegel aufgrund der Mehrzahl von aktiven Bereichen auf diese Bereiche verteilt wird, kann die Konversionseffizienz des Halbleiterbauelements 1 von elektrischer Leistung in Strahlungsleistung gegenüber einem Bauelement mit lediglich einem aktiven Bereich im Halbleiterkörper erhöht werden.

Alternativ oder ergänzend kann der Pumpstrom auch nicht über den Resonator-Braggspiegel 11 und/oder 12 beziehungsweise das Substrat 3 zu den aktiven Bereichen geleitet werden. Hierfür ist einer oder eine Mehrzahl von sogenannten Intra-Cavity-Kontakten, das heißt ein Kontakt, mittels dem Strom innerhalb des Resonators, insbesondere zwischen einem Resonator-Endspiegel und dem diesem nächstliegenden aktiven Bereich, in den Halbleiterkörper injiziert wird. Der vom Pumpstrom zu überwindende Widerstand kann so verringert werden. Ein Resonator-Endspiegel, dem der Intra-Cavity-Kontakt nachgeordnet ist, kann dann gegebenenfalls als undotierter Braggspiegel ausgeführt sein. Alternativ kann auch ein elektrisch isolierender, dielektrischer Spiegelschichtstapel, der bevorzugt auf dem Halbleiterkörper ausgebildet ist, als Resonator-Endspiegel eingesetzt werden.

Der Tunnelübergang 5 ist bevorzugt als im Betrieb des Halbleiterbauelements in Durchlassrichtung für die aktiven Bereiche 4a und 4b, insbesondere bezüglich der Kontakte 13 und 14, als in Sperrrichtung gepolte Diode ausgeführt.

Der Tunnelübergang umfasst beispielsweise zwei Tunnelschichten 51 und 52 unterschiedlichen Leitungstyps. Die Tunnelschicht 52 weist bevorzugt den gleichen Leitungstyp, insbesondere n-leitend, auf wie eine seitens der Tunnelschicht 52, das heißt an der der Tunnelschicht 51 abgewandten Seite der Tunnelschicht 52, an den Tunnelübergang 5 angrenzende Halbleiterschicht des Braggspiegels 7 auf. Besonders bevorzugt weist die Tunnelschicht 52 eine höhere Dotierstoffkonzentration (zum Beispiel n⁺) als diese angrenzende Halbleiterschicht auf. Entsprechendes gilt für die Tunnelschicht 51 (zum Beispiel p⁺) bezüglich einer seitens dieser Tunnelschicht 51 an den Tunnelübergang 5 angrenzenden, insbesondere p-leitenden, Halbleiterschicht des Braggspiegels 8 des frequenzselektiven Elements.

Die Tunnelschichten 51 und 52 weisen bevorzugt jeweils eine Dicke von 30 nm oder weniger, besonders bevorzugt 20 nm oder weniger, auf. Die Tunnelschichten 51 und 52 können eine Dotierstoffkonzentration von beispielsweise 5x10¹⁹cm⁻³ oder mehr, bevorzugt von 1x10²⁰cm⁻³ oder mehr, aufweisen. (Al)GaAs-Schichten mit einem Al-Gehalt von 20% oder weniger sind für die jeweilige Tunnelschicht besonders geeignet.

Die Resonatorlänge beträgt bevorzugt n*(λ/2), wobei λ die Wellenlänge der im Resonator zu verstärkenden Strahlung und n eine natürliche Zahl bezeichnet. n ist bevorzugt größer oder gleich 3. n ist weiterhin bevorzugt derart gewählt, dass die Resonatorlänge kleiner oder gleich 6 λ pro aktivem Bereich des Halbleiterbauelements ist.

Die innerhalb des Resonators angeordneten Elemente des Halbleiterkörpers 2, das heißt alle Halbleiterelemente bis auf die Resonator-Endspiegel, können - abgesehen von den aktiven Bereichen 4a und 4b - bis auf gegebenenfalls unterschiedliche Leitungstypen und/oder Dotierstoffkonzentrationen die gleiche Materialzusammensetzung aufweisen. Insbesondere können der Tunnelübergang 5 und die angrenzenden Halbleiterelemente bis auf die Dotierstoffkonzentration die gleiche Zusammensetzung aufweisen. Brechungsindexsprünge innerhalb dieser Elemente im gemeinsamen Resonator mit damit einhergehender vermehrter Reflexion an Grenzflächen können so vermindert werden.

Alternativ können für die innerhalb des Resonators angeordneten Elemente, das heißt insbesondere für den Tunnelübergang und die angrenzenden Halbleiterelemente, jeweils verschiedene Materialien eingesetzt werden. Die Freiheitsgrade für das Ausbilden dieser Elemente sind so erhöht.

Auch Kombinationen aus derart gleichartiger Ausbildung und verschiedener Ausbildung der einzelnen Halbleiterelemente im Resonator sind möglich. Beispielsweise können alle Elemente zwischen dem Resonator-Endspiegel 12 und dem Tunnelübergang 5, gegebenenfalls einschließlich des Tunnelübergangs, bis auf den dort angeordneten aktiven Bereich, gleiche Materialzusammensetzung aufweisen. Die zwischen dem Tunnelübergang 5 und dem Resonator-Endspiegel 11 angeordneten Elemente des Halbleiterkörpers 2 können verschiedene Materialzusammensetzungen aufweisen.

Weiterhin sind die aktiven Bereiche bevorzugt gleichartig, insbesondere mit gleichen Materialien und/oder dem gleichen strukturellen Aufbau ausgebildet. Vorzugsweise sind die aktiven Bereiche zur Erzeugung von Strahlung gleicher Wellenlänge ausgeführt. Alternativ sind die aktiven Bereiche zur Erzeugung von Strahlung unterschiedlicher Wellenlänge ausgeführt.

Bevorzugt umfassen die aktiven Bereiche ferner jeweils eine Ein- oder Mehrfach-Quantentopfstruktur. Diese Strukturen zeichnen sich durch besonders hohe interne Quanteneffizienzen bei der Umwandlung von elektrischer Leistung in Strahlungsleistung aus. Die Verstärkung von Strahlung im Halbleiterkörper bezogen auf die Ladungsträgerdichte kann so vereinfacht vergrößert werden.

Der Halbleiterkörper ist weiterhin bevorzugt derart ausgebildet, dass jeweils ein Intensitätsmaximum (Intensitätsbauch) 18 einer Intensitätsverteilung des sich im Resonator ausbildenden und in den aktiven Bereichen zu verstärkenden Strahlungsfeldes, insbesondere einer vorgegebenen Mode dieses Strahlungsfeldes, in dem aktiven Bereich 4a beziehungsweise 4b angeordnet ist. Die Intensitätsverteilung 17 im Resonator ist in Figur 1 lediglich schematisch und normiert dargestellt.

Alternativ oder zusätzlich kann einer oder eine Mehrzahl von aktiven Bereichen auch gezielt außerhalb eines Intensitätsbauchs angeordnet sein. Hierzu kann die Dicke eines p-leitenden Bereichs in Bereichen vergleichsweise hoher Strahlungsintensität im Halbleiterkörper verringert werden und die Dicke eines n-leitenden Bereichs, insbesondere für eine vorgegebene Resonatorlänge, entsprechend vergrößert werden. In einem p-leitenden Bereich ist die Absorption von Strahlung durch freie Ladungsträger oftmals besonders groß und insbesondere größer als in einem n-leitenden Bereich. Insbesondere gilt dies im AlGaAs-Materialsystem.

Der jeweilige aktive Bereich ist bevorzugt derart zum nächstliegenden Intensitätsbauch versetzt angeordnet, dass dieser in Richtung eines n-leitenden Halbleiterbereichs verschoben ist oder in diesem liegt. Hierfür kann ein gegebenenfalls zusätzlicher n-leitender Bereich, zum Beispiel der Braggspiegel 7 oder der Halbleiterbereich 9a, entsprechend dicker ausgeführt sein. Auch hierüber kann trotz der Anordnung des aktiven Bereichs außerhalb eines Intensitätsbauchs die Effizienz des Halbleiterbauelements vorteilhaft erhöht werden, da Strahlung im Resonator kürzer durch p-leitendes Halbleitermaterial läuft.

Der Halbleiterkörper 2 ist weiterhin bevorzugt derart ausgebildet, dass ein Intensitätsknoten 20 der Intensitätsverteilung 17 innerhalb des Tunnelübergangs 5 angeordnet ist. Die Absorption von Strahlung durch freie Ladungsträger im Tunnelübergang 5, der diesbezüglich in der Regel ein vergleichsweise hohes Absorptionsvermögen zeigt, kann so vermindert werden. Hierdurch wird die Konversionseffizienz und insbesondere auch die über die Emissionsoberfläche 200 ausgekoppelte Strahlungsleistung vereinfacht erhöht.

Ferner wird die differenzielle Effizienz dPₒₚₜ/dI, mit der ausgekoppelten Strahlungsleistung Pₒₚₜ und dem injizierten Strom I, und/oder die differenzielle Verstärkung dg/dn, mit der Verstärkung g ("gain") und der Ladungsträgerdichte n, vorteilhaft erhöht.

Über die Braggspiegel 7 und 8 des frequenzselektiven Elements 6 werden durch Reflexion im Halbleiterkörper zusätzliche Phasenbedingungen im Resonator geschaffen. Bevorzugt sind die Braggspiegel derart ausgebildet, dass die Intensität innerhalb des frequenzselektiven Elements und damit auch im Bereich des Tunnelübergangs gemindert ist. Insbesondere kann eine einhüllende Kurve der Intensitätsverteilung des Feldes stehender Wellen im Halbleiterkörper mittels des frequenzselektiven Elements derart geformt werden, dass diese einhüllende Kurve ein lokales Minimum innerhalb des frequenzselektiven Elements, insbesondere zwischen den Braggspiegeln des Elements, aufweist. Bevorzugt ist der Tunnelübergang derart im Halbleiterkörper angeordnet, dass er in einer Umgebung des mittels des frequenzselektiven Elements erzeugten lokalen Minimums, insbesondere zwischen zwei lokalen Maxima, der einhüllenden Kurve der Intensitätsverteilung 17 im Halbleiterkörper 2, angeordnet ist. Bevorzugt ist der Tunnelübergang derart angeordnet, dass das lokale Minimum der einhüllenden Kurve in dem Tunnelübergang liegt. Die Fertigungstoleranzen bei der Ausbildung des Tunnelübergangs werden so erhöht, da auch bei einer geringen Abweichung der Anordnung des Tunnelübergangs von der optimalen Anordnung in einem Intensitätsknoten die im Tunnelübergang absorbierbare Strahlungsleistung aufgrund der modulierten Intensitätsverteilung vorteilhaft gering ist. Eine Reflektivität der Braggspiegel 7 und 8 von 30% oder mehr, bevorzugt von 40% oder mehr, für im Resonator zu verstärkende Strahlung der Wellenlänge λ ist zur Intensitätsmodulation besonders geeignet.

Bevorzugt weisen die Braggspiegel 7 und 8 des frequenzselektiven Elements eine Reflektivität von 95% oder weniger oder 90% oder weniger, besonders bevorzugt von 80% oder weniger, für die in den aktiven Bereichen 4a und 4b zu verstärkende Strahlung auf. Das Anschwingen von Laser-Submoden in Subresonatoren zwischen dem Braggspiegel 7 und dem Resonator-Endspiegel 11 beziehungsweise dem Braggspiegel 8 und dem Resonator-Endspiegel 12 kann so verhindert werden.

Der Resonator ist demnach insbesondere als gemeinsamer Resonator für die aktiven Bereiche 4a und 4b und nicht als Übereinanderanordnung separater Resonatoren ausgebildet. Ein nachteiliger Einfluss der Braggspiegel des frequenzselektiven Elements auf die Lasereigenschaften des Halbleiterbauelements kann so vermieden werden.

Die Einzelschichten des jeweiligen Braggspiegels des frequenzselektiven Elements können alternativ oder ergänzend auch als λ₁/4-Schichten für Strahlung einer Wellenlänge λ₁ ausgebildet sein, die von der Wellenlänge λ der mittels des Resonators zu verstärkenden Strahlung, für die die Resonator-Endspiegel zweckmäßigerweise hochreflektiv ausgebildet sind, abweicht. Diese Abweichung kann bis zu 10% betragen.

Weiterhin kann das frequenzselektive Element alternativ oder zusätzlich, etwa als monolithisch in den Halbleiterkörper integriertes, etalonartiges Element, zur longitudinalen Modenselektion ausgebildet sein. Ein longitudinal monomodiger Betrieb des Halbleiterbauelements wird so gefördert.

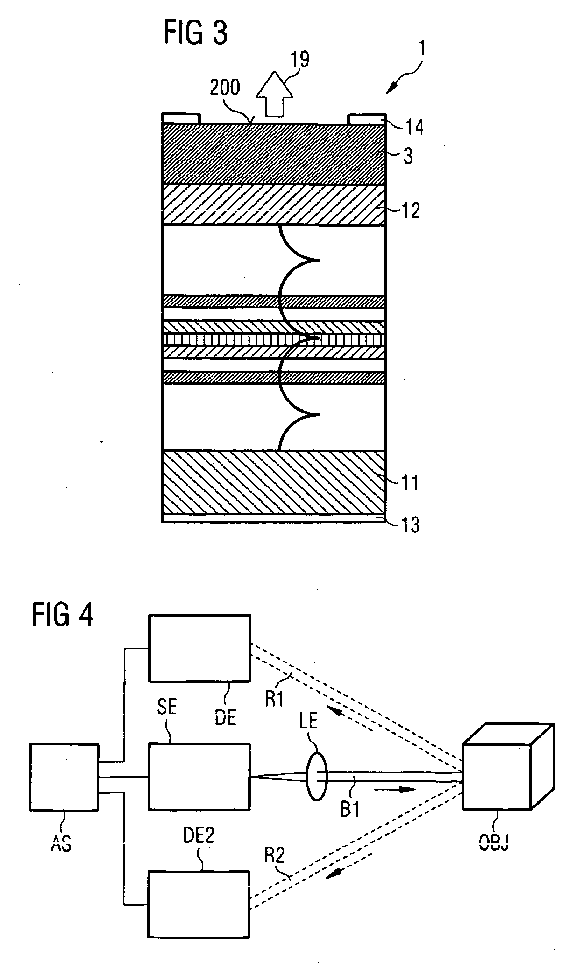

Figur 3 zeigt eine schematische Schnittansicht eines weiteren Ausführungsbeispiels eines Halbleiterbauelements 1, welches in der Strahlungseinrichtung SE verwendet werden kann. Im Wesentlichen entspricht das in Figur 3 gezeigte Halbleiterbauelement dem in der Figur 2 beschriebenen Halbleiterbauelement. Im Unterschied hierzu ist das Halbleiterbauelement als sogenannter Bottom-Emitter ausgebildet. Die Strahlung 19 verlässt den Halbleiterkörper 2 also über die dem Substrat 3 zugewandte Seite des Halbleiterkörpers und tritt durch den Bereich des Substrats 3 hindurch. Dieses ist hierzu bevorzugt strahlungsdurchlässig ausgeführt. Als Auskoppelspiegel dient hierbei zweckmäßigerweise der Resonator-Endspiegel 12, der dem Substrat 3 zugewandt ist. Gegebenenfalls kann das Substrat 3 für den Strahlungsdurchtritt auch - vollständig oder bereichsweise - entfernt oder gedünnt sein. Der zweite Kontakt 14 ist für den Strahlungsdurchtritt entsprechend dem ersten Kontakt 13 gemäß Figur 2 vorzugsweise als Ringkontakt ausgeführt. Der zweite Resonator-Endspiegel 12 weist als Auskoppelspiegel zweckmäßigerweise eine geringere Reflektivität auf als der Resonator-Endspiegel 11.

Figur 4 zeigt ein weiteres Ausführungsbeispiel einer Messanordnung. Dabei ist neben den in Figur 1 dargestellten Elementen zusätzlich eine weitere Detektionseinrichtung DE2 vorgesehen, die in räumlichem Abstand zur ersten Detektionseinrichtung DE angeordnet ist.

Beispielsweise wird die von der Strahlungseinrichtung SE im Betrieb emittierte Strahlung B1 vom Messobjekt OBJ derart reflektiert, dass sich eine erste reflektierte Strahlung R1 oder eine zweite reflektierte Strahlung R2 oder eine erste und eine zweite reflektierte Strahlung R1, R2 ergeben. Somit kann die reflektierte Strahlung R1, R2 von der ersten Detektionseinrichtung DE und/oder der zweiten Detektionseinrichtung DE2 detektiert werden. Eine Auswertung der detektierten, reflektierten Strahlung R1, R2 als Detektionsergebnis kann wiederum in der Auswerteschaltung AS erfolgen, wie zuvor für das Ausführungsbeispiel in Figur 1 beschrieben.

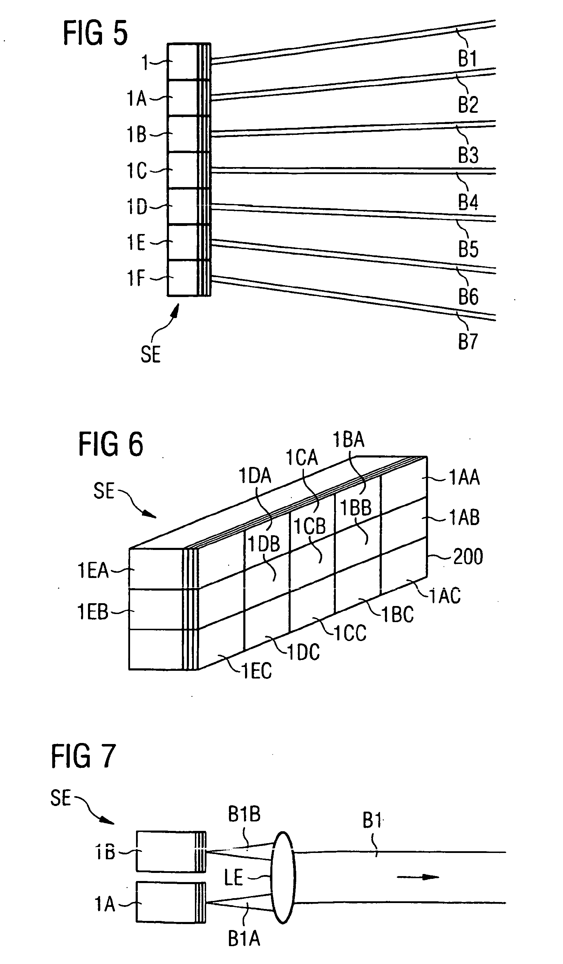

Figur 5 zeigt ein Ausführungsbeispiel einer Sendeeinrichtung SE, bei der eine Mehrzahl von oberflächenemittierenden Halbleiterbauelementen 1, 1A bis 1F vorgesehen sind, welche ein eindimensionales Strahlungsfeld bilden. In dem in Figur 5 gezeigten Ausführungsbeispiel sind die Halbleiterbauelemente derart angeordnet, dass die jeweils von den Bauelementen emittierte Strahlung B1 bis B7 jeweils einen unterschiedlichen Winkel zur Oberfläche des Strahlungsfeldes bilden. Beispielsweise lässt sich jedes der Halbleiterelemente 1, 1A bis 1F individuell ansteuern, so dass jeweils nur ein, beispielsweise pulsförmiger, Strahl B1 bis B7 von der Strahlungseinrichtung SE emittiert wird. Beispielsweise können mit einer Strahlungseinrichtung SE gemäß dem gezeigten Ausführungsbeispiel Entfernungen zu Punkten eines breiteren Objekts gemessen werden. So lässt sich etwa die Kontur eines breiteren Messobjekts bestimmen. Für eine Detektion jeweils reflektierter Strahlung kann eine Detektionseinrichtung ausreichend sein. Alternativ können mehrere Detektionseinrichtungen vorgesehen werden.

Figur 6 zeigt ein weiteres Ausführungsbeispiel eines Strahlungsfelds, in dem mehrere oberflächenemittierende Halbleiterelemente ein zweidimensionales Strahlungsfeld bilden. In der gezeigten Strahlungseinrichtung sind dazu beispielhaft fünf mal drei Halbleiterbauelemente 1AA, 1AB, 1AC, 1BA, 1BB, 1BC, 1CA, 1CB, 1CC, 1DA, 1DB, 1DC, 1EA, 1EB, 1EC vorgesehen, welche in einer Matrix rechteckförmig angeordnet sind. Die strahlungsemittierenden Halbleiterbauelemente 1AA bis 1EC weisen eine gemeinsame Strahlungsfläche 200 auf, über die jeweils Strahlung, vorzugsweise Laserstrahlung emittierbar ist. Ähnlich wie bei dem eindimensionalen Strahlungsfeld aus Figur 5 können die Halbleiterbauelemente des zweidimensionalen Strahlungsfelds jeweils unterschiedliche Strahlungswinkel zur Strahlungsfläche 200 aufweisen und sich individuell ansteuern lassen. Somit lassen sich beispielsweise Entfernungen zu Punkten auf einer Oberfläche eines Messobjekts bestimmen, um daraus eine Oberflächenstruktur des Objekts abzuleiten.

Figur 7 zeigt ein weiteres Ausführungsbeispiel einer Strahlungseinrichtung SE. Dabei umfasst die Strahlungseinrichtung SE ein erstes und ein zweites strahlungsemittierendes Halbleiterbauelement 1A, 1B welche zur Emission jeweils eines Einzelstrahls B1A, B1B ausgebildet sind. Ferner ist eine Linse LE vorgesehen, welche zur Kollimierung, das heißt Bündelung der beiden Teilstrahlen B1A, B1B zu einem gemeinsamen Strahl B1 vorgesehen ist. Somit weist der Strahl B1 eine höhere Strahlungsdichte auf als ein jeweiliger Einzelstrahl B1A, B1B. In weiteren Ausführungsformen können auch Einzelstrahlen mehrerer Halbleiterbauelemente zu einem gemeinsamen Strahl B1 gebündelt werden.

Die von der Strahlungseinrichtung SE beziehungsweise von den Halbleiterbauelementen 1 emittierten Strahlungen B1 können auch durch andere optische Elemente geformt oder geführt werden.

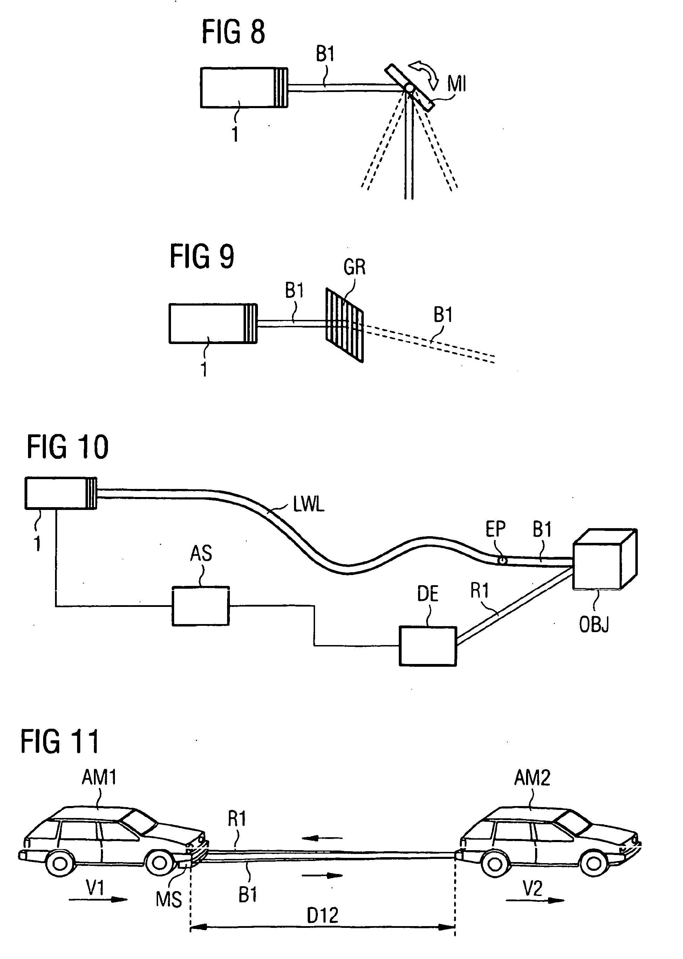

Figur 8 zeigt ein Ausführungsbeispiel eines strahlungsemittierenden Halbleiterelements 1 mit einem Spiegel MI, welcher beweglich gelagert ist. Die Strahlung B1 des Halbleiterelements 1 trifft auf den Spiegel MI und wird in Abhängigkeit der Stellung beziehungsweise des Winkels des Spiegels in einer von vielen möglichen Winkeln abgeleitet beziehungsweise reflektiert. Ähnlich wie beim eindimensionalen Strahlungsfeld können somit Strahlungspulse auf unterschiedliche Positionen oder Punkte eines Messobjekts gerichtet werden, um beispielsweise eine Kontur des Messobjekts zu bestimmen.

Figur 9 zeigt ein weiteres Ausführungsbeispiel eines Halbleiterelements 1 mit einem optischen Element, welches in diesem Ausführungsbeispiel als optisches Gitter GR ausgeführt ist. Dabei wird der vom Halbleiterelement 1 emittierter Strahl B1 am Gitter GR gebeugt, so dass es zu einer Ablenkung des Strahls B1 von der ursprünglichen Strahlungsrichtung kommt. Bei einer optischen Beeinflussung eines Strahls durch ein optisches Gitter kann man auch von einer diffraktiven Beeinflussung sprechen. In einem alternativen Ausführungsbeispiel kann das optische Gitter GR auch durch einen optischen Spalt ersetzt werden, durch den ebenfalls eine diffraktive Ablenkung des Strahls B1 erfolgt.

Figur 10 zeigt ein weiteres Ausführungsbeispiel einer Messanordnung mit einer Auswerteschaltung AS, einem Halbleiterbauelement 1 und einer Detektionseinrichtung DE. Ferner ist eine Lichtleitfaser LWL vorgesehen, in die die vom Halbleiterbauelement 1 emittierte Strahlung eingekoppelt werden kann, um sie über die Lichtleitfaser LWL zu einem eigentlichen Emissionspunkt EP zu transportieren. Ähnlich wie bei dem Ausführungsbeispiel in Figur 1 kann ein Strahl B1 emittiert werden, welcher auf ein Messobjekt OBJ trifft und von diesem als reflektierter Strahl R1 zurückgestrahlt wird. Die reflektierte Strahlung R1 kann wiederum von der Detektionseinrichtung DE detektiert und in der Auswerteschaltung AS verarbeitet werden.

Figur 11 zeigt ein Ausführungsbeispiel eines Messsystems MS mit einer Messanordnung nach einem der beschriebenen Ausführungsbeispiele, wobei das Messsystem MS als Abstandsregeltempomat ausgebildet ist. Dazu sind in Figur 11 ein erstes und ein zweites Fahrzeug AM1, AM2 dargestellt, welche sich mit einer ersten Geschwindigkeit V1 beziehungsweise einer zweiten Geschwindigkeit V2 bewegen. Das erste Fahrzeug AM1 weist das angesprochene Messsystem MS auf, welches im Betrieb Strahlung, beispielsweise als Laserstrahl B1, emittiert, welche von dem zweiten Fahrzeug AM2 als reflektierte Strahlung R1 zurückgeworfen wird. Wie zuvor beschrieben, kann die reflektierte Strahlung R1 von der Detektionseinrichtung in der Messanordnung des Messsystems MS detektiert werden. Somit kann beispielsweise über die Laufzeit der Strahlung B1 beziehungsweise R1 ein Abstand D12 zwischen dem ersten und dem zweiten Fahrzeug AM1, AM2 sowie eine Relativgeschwindigkeit des zweiten Fahrzeugs AM2 zum ersten Fahrzeug AM1 bestimmt werden. Eine derart bestimmte relative Geschwindigkeit entspricht dabei einem Wert einer Geschwindigkeitsdifferenz zwischen zweiter und erster Geschwindigkeit V2-V1.

Wenn beispielsweise dem Messsystem die Geschwindigkeit V1 des ersten Fahrzeugs AM1 bekannt ist, kann somit auch die absolute Geschwindigkeit V2 des zweiten Fahrzeugs AM2 ermittelt werden. Mit der ermittelten (relativen) Geschwindigkeit kann beispielsweise ein Anpassung der Geschwindigkeit V1 des ersten Fahrzeugs AM1 vorgenommen werden, um beispielsweise einen vorgegebenen Abstand zwischen den Fahrzeugen AM1, AM2 einzuhalten beziehungsweise zu erreichen.

Insbesondere ist die Erfindung nicht als auf eine Messanordnung oder ein Messsystem mit einem strahlungsemittierenden Halbleiterbauelement mit nur zwei aktiven Bereichen beschränkt anzusehen. Vielmehr kann auch eine größere Anzahl von aktiven Bereichen, vorzugsweise in einem gemeinsamen Resonator, vorgesehen sein. Diese aktiven Bereiche sind vorzugsweise jeweils paarweise durch einen zwischen je zwei aktiven Bereichen angeordneten Tunnelübergang, gegebenenfalls jeweils mit einem den Tunnelübergang umgebenden frequenzselektiven Element, in Serie elektrisch leitend verbunden. Beispielsweise können bis zu zehn aktive Bereiche vorgesehen sein. Auf diese Weise kann die Effizienz des Halbleiterbauelements gegebenenfalls weitergehend erhöht werden.

Ferner kann auch eine ein- oder zweidimensionale, lineare beziehungsweise flächige, vorzugsweise matrixartige, Anordnung von Halbleiterbauelementen in der Strahlungseinrichtung als von der Erfindung umfasst angesehen werden. Bevorzugt ist diese Anordnung monolithisch integriert, das heißt mittels epitaktischen Aufwachsens einer Halbleiterschichtenfolge für die Halbleiterkörper der verschiedenen Halbleiterbauelemente und vorzugsweisen Ausbildens der Bauelemente auf einem einzelnen Aufwachssubstrat, ausgeführt. Hierdurch kann eine Vielzahl von Halbleiterbauelementen mit geringem Abstand auf kleinem Raum konzentriert werden.

## Patentansprüche

1. Messanordnung, umfassend
- eine Strahlungseinrichtung (SE), aufweisend wenigstens ein erstes oberflächenemittierendes Halbleiterbauelement (1) mit einer vertikalen Emissionsrichtung;
- eine Detektionseinrichtung (DE) zur Detektion reflektierter Strahlung; und
- eine Auswerteschaltung (AS), eingerichtet zur Steuerung der Strahlungseinrichtung (SE) und der Detektionseinrichtung (DE) sowie zur Verarbeitung eines Detektionsergebnisses der Detektionseinrichtung (DE);
**dadurch gekennzeichnet, dass**
das Halbleiterbauelement einen Halbleiterkörper (2) mit einer Mehrzahl von zur Erzeugung von Strahlung geeigneten, in vertikaler Richtung voneinander beabstandet angeordneten aktiven Bereichen (4a, 4b) umfasst, bei dem zwischen zwei benachbarten aktiven Bereichen (4a, 4b) ein Tunnelübergang (5) im Halbleiterkörper (2) monolithisch integriert ist und die beiden benachbarten aktiven Bereiche mittels des Tunnelübergangs im Betrieb des Halbleiterbauelements (1) elektrisch leitend verbunden sind, wobei zwischen den benachbarten aktiven Bereichen (4a, 4b), die über den Tunnelübergang elektrisch leitend verbunden sind, ein frequenzselektives Element (6), das einen ersten und einen zweiten Braggspiegel (7, 8) aufweist, angeordnet ist und der Tunnelübergang zwischen den beiden Braggspiegeln (7, 8) des frequenzselektiven Elements (6) angeordnet ist.

2. Messanordnung nach Anspruch 1,
bei der das frequenzselektive Element (6) derart ausgebildet ist, dass die Intensität der erzeugten Strahlung im Halbleiterkörper (2) innerhalb des frequenzselektiven Elements (6) gemindert ist.

3. Messanordnung nach Anspruch 1 oder 2,
bei der der erste und/oder der zweite Braggspiegel (7, 8) eine Reflektivität von 95% oder weniger aufweist.

4. Messanordnung nach Anspruch 3,
bei der der erste und/oder der zweite Braggspiegel (7, 8) eine Reflektivität von 90% oder weniger aufweist.

5. Messanordnung nach Anspruch 3,
bei der der erste und/oder der zweite Braggspiegel (7, 8) eine Reflektivität 80% oder weniger, aufweist.

6. Messanordnung nach einem der Ansprüche 1 bis 5,
bei der die beiden Braggspiegel (7, 8) unterschiedliche Leitungstypen aufweisen.

7. Messanordnung nach einem der Ansprüche 1 bis 6,
bei der das frequenzselektive Element (6) monolithisch im Halbleiterkörper (2) integriert ist.

8. Messanordnung nach einem der Ansprüche 1 bis 7,
bei der zwischen zwei der aktiven Bereiche (4a, 4b) eine Stromblende (23) ausgebildet ist.

9. Messanordnung nach einem der Ansprüche 1 bis 8,
bei der das Halbleiterbauelement (1) einen internen Resonator aufweist oder für den Betrieb mit einem externen Resonator ausgebildet ist.

10. Messanordnung nach Anspruch 9,
bei der im Halbleiterkörper (2) zwei aktive Bereiche (4a, 4b) als Verstärkungsbereiche innerhalb des Resonators angeordnet sind und der Resonator als gemeinsamer Resonator für beide aktiven Bereiche ausgebildet ist.

11. Messanordnung nach Anspruch 9 oder 10,
bei der der Halbleiterkörper (2) derart ausgebildet ist, dass ein sich im Betrieb des Halbleiterbauelements (1) innerhalb des Resonators ausbildendes Strahlungsfeld (17) ein Intensitätsminimum (20) innerhalb des Tunnelübergangs aufweist.

12. Messanordnung nach einem der Ansprüche 9 bis 11,
bei der der Resonator mittels eines ersten Resonatorspiegels (11, 12) und eines zweiten Resonatorspiegels (11, 12) gebildet ist.

13. Messanordnung nach Anspruch 12,
bei der der erste Resonatorspiegel (11, 12) und/oder der zweite Resonatorspiegel (11, 12) als Braggspiegel ausgeführt ist.

14. Messanordnung nach Anspruch 12 oder 13,
bei der zumindest ein Resonatorspiegel (11, 12) dotiert ist.

15. Messanordnung nach einem der Ansprüche 12 bis 14,
bei der die Resonatorspiegel (11, 12) eine der folgenden Ausgestaltungen aufweisen: gleicher Leitungstyp, verschiedener Leitungstyp.

16. Messanordnung nach einem der Ansprüche 12 bis 15,
bei der beide Resonatorspiegel (11, 12) n-leitend ausgeführt sind.

17. Messanordnung nach einem der Ansprüche 1 bis 16,
bei der das Halbleiterbauelement (1) zum Betrieb als elektrisch gepumptes Halbleiterlaserbauelement ausgeführt ist.

18. Messanordnung nach einem der Ansprüche 1 bis 17,
bei der das Halbleiterbauelement (1) als VCSEL ausgebildet ist.

19. Messanordnung nach einem der Ansprüche 1 bis 18,
bei der zwei der aktiven Bereiche (4a, 4b) eine Quantentopfstruktur umfassen.

20. Messanordnung nach einem der Ansprüche 1 bis 19,
bei der der Tunnelübergang (5) zwei Tunnel-Halbleiterschichten (51, 52) unterschiedlichen Leitungstyps aufweist.

21. Messanordnung nach einem der Ansprüche 1 bis 20,
bei der der Halbleiterkörper (2) ein III-V-Halbleitermaterial, insbesondere ein Material aus den III-V-Halbleitermaterialsystemen Inₓ Ga_{y} Al_{1-x-y} P, Inₓ Ga_{y} Al_{1-x-y} N oder InₓGa_{y}Al_{1-x-y} As, jeweils mit 0≤x≤1, 0≤y≤1 und x+y≤1, enthält.

22. Messanordnung nach einem der Ansprüche 1 bis 21,
bei der der Halbleiterkörper (2) ein III-V-Halbleitermaterial, insbesondere ein Material aus den III-V-Halbleitermaterialsystemen InGaAsN, InGaAsSb, InGaAsSbN oder Inₓ Ga₁₋ₓ As_{y} P_{1-y} mit 0≤x≤1 und 0≤y≤1, enthält.

23. Messanordnung nach einem der Ansprüche 1 bis 22,
bei der wenigstens zwei der aktiven Bereiche (4a, 4b) für Strahlung unterschiedlicher Wellenlänge ausgeführt sind.

24. Messanordnung nach einem der Ansprüche 1 bis 23,
bei der die Detektionseinrichtung (DE) wenigstens ein erstes Photohalbleiterelement aufweist.

25. Messanordnung nach Anspruch 24,
bei der das wenigstens eine erste Photohalbleiterelement als Photodiode oder als Phototransistor oder als Photowiderstand ausgeführt ist.

26. Messanordnung nach einem der Ansprüche 1 bis 25,
bei der eine zweite Detektionseinrichtung (DE2) zur Detektion reflektierter Strahlung vorgesehen ist, welche mit der Auswerteschaltung (AS) zur Steuerung und Verarbeitung gekoppelt ist.

27. Messanordnung nach einem der Ansprüche 1 bis 26,
bei der die Strahlungseinrichtung (SE) eine Mehrzahl von oberflächenemittierenden Halbleiterbauelementen entsprechend dem ersten oberflächenemittierenden Halbleiterbauelement (1) aufweist.

28. Messanordnung nach Anspruch 27,
bei der die Mehrzahl von oberflächenemittierenden Halbleiterbauelementen als eindimensionales oder zweidimensionales Strahlungsfeld angeordnet sind.

29. Messanordnung nach Anspruch 27 oder 28,
bei der eine Strahlungsemission der Mehrzahl von oberflächenemittierenden Halbleiterbauelementen einzeln steuerbar ist.

30. Messanordnung nach einem der Ansprüche 27 bis 29,
bei der eine Strahlungsemission der Mehrzahl von oberflächenemittierenden Halbleiterbauelementen gebündelt erfolgen kann.

31. Messanordnung nach einem der Ansprüche 1 bis 30,
bei der die Messanordnung wenigstens ein optisches Element zur Strahlformung und/oder zur Strahlführung der von der Strahlungseinrichtung (SE) emittierten Strahlung umfasst.

32. Messanordnung nach Anspruch 31,
bei der das wenigstens eine optische Element wenigstens eines der folgenden Elemente aufweist:
- einen Spiegel;
- einen optischen Spalt;
- ein optisches Gitter;
- eine Linse;
- eine Lichtleitfaser.

33. Messanordnung nach einem der Ansprüche 1 bis 32,
bei der die Auswerteschaltung (AS) eingerichtet ist, eine Strahlungsemission des ersten oberflächenemittierenden Halbleiterbauelements (1) pulsförmig zu steuern.

34. Messsystem mit einer Messanordnung nach einem der Ansprüche 1 bis 33, das Messsystem eingerichtet zur Entfernungsmessung.

35. Messsystem mit einer Messanordnung nach einem der Ansprüche 1 bis 33, das Messsystem eingerichtet zur Geschwindigkeitsmessung.

36. Messsystem mit einer Messanordnung nach einem der Ansprüche 1 bis 33, das Messsystem ausgebildet als Abstandsregeltempomat.

## Claims

1. Measuring arrangement, comprising
- a radiation device (SE), having at least one first surface emitting semiconductor component (1) with a vertical emission direction
- a detection device (DE) for detecting reflected radiation; and
- an evaluation circuit (AS), set up for controlling the radiation device (SE) and the detection device (DE) and for processing a detection result of the detection device (DE);
**characterized in that** the semiconductor component comprises a semiconductor body (2) with a plurality of active regions (4a, 4b) suitable for generating radiation and arranged at a distance from one another in a vertical direction, in which a tunnel junction (5) is monolithically integrated in the semiconductor body (2) between two adjacent active regions (4a, 4b) and the two adjacent active regions are electrically conductively connected by means of the tunnel junction during operation of the semiconductor component (1), wherein a frequency-selective element (6) having a first and a second Bragg mirror (7, 8) is arranged between the adjacent active regions (4a, 4b) which are electrically conductively connected via the tunnel junction, and the tunnel junction is arranged between the two Bragg mirrors (7, 8) of the frequency-selective element (6).

2. Measuring arrangement according to Claim 1,
in which the frequency-selective element (6) is formed in such a way that the intensity of the generated radiation in the semiconductor body (2) is reduced within the frequency-selective element (6).

3. Measuring arrangement according to Claim 1 or 2,
in which the first and/or the second Bragg mirror (7, 8) has a reflectivity of 95% or less.

4. Measuring arrangement according to Claim 3, in which the first and/or the second Bragg mirror (7, 8) has a reflectivity of 90% or less.

5. Measuring arrangement according to Claim 3, in which the first and/or the second Bragg mirror (7, 8) has a reflectivity of 80% or less.

6. Measuring arrangement according to one of Claims 1 to 5,
in which the two Bragg mirrors (7, 8) have different conduction types.

7. Measuring arrangement according to one of Claims 1 to 6,
in which the frequency-selective element (6) is monolithically integrated in the semiconductor body (2).

8. Measuring arrangement according to one of Claims 1 to 7,
in which a current diaphragm (23) is formed between two of the active regions (4a, 4b).

9. Measuring arrangement according to one of Claims 1 to 8,
in which the semiconductor component (1) has an internal resonator or is designed for operation with an external resonator.

10. Measuring arrangement according to Claim 9,
in which, in the semiconductor body (2), two active regions (4a, 4b) are arranged as amplifying regions within the resonator and the resonator is formed as a common resonator for both active regions.

11. Measuring arrangement according to Claim 9 or 10,
in which the semiconductor body (2) is formed in such a way that a radiation field (17) that forms within the resonator during operation of the semiconductor component (1) has an intensity minimum (20) within the tunnel junction.

12. Measuring arrangement according to one of Claims 9 to 11,
in which the resonator is formed by means of a first resonator mirror (11, 12) and a second resonator mirror (11, 12).

13. Measuring arrangement according to Claim 12,
in which the first resonator mirror (11, 12) and/or the second resonator mirror (11, 12) are/is embodied as Bragg mirror(s).

14. Measuring arrangement according to Claim 12 or 13,
in which at least one resonator mirror (11, 12) is doped.

15. Measuring arrangement according to one of Claims 12 to 14,
in which the resonator mirrors (11, 12) have one of the following configurations: identical conduction type, different conduction type.

16. Measuring arrangement according to one of Claims 12 to 15,
in which both resonator mirrors (11, 12) are embodied in n-conducting fashion.

17. Measuring arrangement according to one of Claims 1 to 16,
in which the semiconductor component (1) is embodied for operation as an electrically pumped semiconductor laser component.

18. Measuring arrangement according to one of Claims 1 to 17,
in which the semiconductor component (1) is formed as a VCSEL.

19. Measuring arrangement according to one of Claims 1 to 18,
in which two of the active regions (4a, 4b) comprise a quantum well structure.

20. Measuring arrangement according to one of Claims 1 to 19,
in which the tunnel junction (5) has two tunnel semiconductor layers (51, 52) of different conduction types.

21. Measuring arrangement according to one of Claims 1 to 20,
in which the semiconductor body (2) contains a III-V semiconductor material, in particular a material from the III-V semiconductor material systems InₓGa_{y}Al_{1-x-y}P, InₓGa_{y}Al_{1-x-y}N or InₓGayAl_{1-x-y}As, in each case where 0≤x≤1, 0≤y≤1 and x+y≤1.

22. Measuring arrangement according to one of Claims 1 to 21,
in which the semiconductor body (2) contains a III-V semiconductor material, in particular a material from the III-V semiconductor material systems InGaAsN, InGaAsSb, InGaAsSbN or InₓGa₁₋ₓAs_{y}P_{1-y} where 0≤x≤1 and 0≤y≤1.

23. Measuring arrangement according to one of Claims 1 to 22,
in which at least two of the active regions (4a, 4b) are embodied for radiation of different wavelengths.

24. Measuring arrangement according to one of Claims 1 to 23,
in which the detection device (DE) has at least one first photosemiconductor element.

25. Measuring arrangement according to Claim 24,
in which the at least one first photosemiconductor element is embodied as a photodiode or as a phototransistor or as a photoresistor.

26. Measuring arrangement according to one of Claims 1 to 25,
in which a second detection device (DE2) for detecting reflected radiation is provided, which is coupled to the evaluation circuit (AS) for control and processing.

27. Measuring arrangement according to one of Claims 1 to 26,
in which the radiation device (SE) has a plurality of surface emitting semiconductor components corresponding to the first surface emitting semiconductor component (1).

28. Measuring arrangement according to Claim 27,
in which the plurality of surface emitting semiconductor components are arranged as a one-dimensional or two-dimensional radiation field.

29. Measuring arrangement according to Claim 27 or 28,
in which a radiation emission of the plurality of surface emitting semiconductor components is individually controllable.

30. Measuring arrangement according to one of Claims 27 to 29,
in which a radiation emission of the plurality of surface emitting semiconductor components can be effected in concentrated fashion.

31. Measuring arrangement according to one of Claims 1 to 30,
in which Measuring arrangement comprises at least one optical element for beam shaping and/or for beam guiding of the radiation emitted by the radiation device (SE).

32. Measuring arrangement according to Claim 31,
in which the at least one optical element has at least one of the following elements:
- a mirror;
- an optical slit;
- an optical grating;
- a lens;
- an optical fiber.

33. Measuring arrangement according to one of Claims 1 to 32,
in which the evaluation circuit (AS) is set up to control a radiation emission of the first surface emitting semiconductor component (1) in pulsed fashion.

34. A measuring system comprising a measuring arrangement according to one of Claims 1 to 33, Measuring system being set up for distance measurement.

35. A measuring system comprising a measuring arrangement according to one of Claims 1 to 33, Measuring system being set up for speed measurement.

36. A measuring system comprising a measuring arrangement according to one of Claims 1 to 33, Measuring system being formed as an adaptive cruise control.

## Revendications

1. Ensemble de mesure comprenant :
- un dispositif (SE) émetteur de rayonnement qui présente au moins un premier composant semi-conducteur (1) émettant en surface dans une direction verticale d'émission,
- un dispositif de détection (DE) qui détecte un rayonnement réfléchi et
- un circuit d'évaluation (AS) conçu pour commander le dispositif (SE) d'émission de rayonnement et le dispositif de détection (DE) et pour traiter un résultat de détection du dispositif de détection (DE), **caractérisé en ce que**
le composant semi-conducteur comporte un corps semi-conducteur (2) doté de plusieurs parties actives (4a, 4b) convenant pour produire un rayonnement et disposées à distance les unes des autres dans la direction verticale,
**en ce qu'**une transition-tunnel (5) est intégrée monolithiquement dans le corps semi-conducteur (2) entre deux parties actives (4a, 4b) voisines,
**en ce que** les deux parties actives voisines sont reliées de manière électriquement conductrice au moyen de la transition-tunnel lorsque le composant semi-conducteur (1) est en fonctionnement,
**en ce qu'**un élément (6) sélectif en fréquence qui présente un premier et un deuxième miroir de Bragg (7, 8) est disposé entre les deux parties actives (4a, 4b) voisines reliées de manière électriquement conductrice par la transition-tunnel et
**en ce que** la transition-tunnel est disposée entre les deux miroirs de Bragg (7, 8) de l'élément (6) sélectif en fréquence.

2. Ensemble de mesure selon la revendication 1, dans lequel l'élément (6) sélectif en fréquence est configuré de telle sorte que l'intensité du rayonnement émis soit diminuée à l'intérieur de l'élément (6) sélectif en fréquence dans le corps semi-conducteur (2).

3. Ensemble de mesure selon les revendications 1 ou 2, dans lequel le premier et/ou le deuxième miroir de Bragg (7, 8) présentent une réflectivité de 95 % ou moins.

4. Ensemble de mesure selon la revendication 3, dans lequel le premier et/ou le deuxième miroir de Bragg (7, 8) présentent une réflectivité de 90 % ou moins.

5. Ensemble de mesure selon la revendication 3, dans lequel le premier et/ou le deuxième miroir de Bragg (7, 8) présentent une réflectivité de 80 % ou moins.

6. Ensemble de mesure selon l'une des revendications 1 à 5, dans lequel les deux miroirs de Bragg (7, 8) présentent des types différents de conduction.

7. Ensemble de mesure selon l'une des revendications 1 à 6, dans lequel l'élément (6) sélectif en fréquence est intégré monolithiquement dans le corps semi-conducteur (2).

8. Ensemble de mesure selon l'une des revendications 1 à 7, dans lequel un écran de courant (23) est formé entre les deux parties actives (4a, 4b).

9. Ensemble de mesure selon l'une des revendications 1 à 8, dans lequel l'élément semi-conducteur (1) présente un résonateur interne ou est configuré pour fonctionner avec un résonateur externe.

10. Ensemble de mesure selon la revendication 9, dans lequel deux parties actives (4a, 4b) sont disposées dans le corps semi-conducteur (2) comme parties d'amplification à l'intérieur du résonateur, le résonateur étant configuré comme résonateur commun pour les deux parties actives.

11. Ensemble de mesure selon les revendications 9 ou 10, dans lequel le corps semi-conducteur (2) est configuré de telle sorte qu'un champ de rayonnement (17) qui se forme à l'intérieur du résonateur lorsque le composant semi-conducteur (1) est en fonctionnement présente un minimum d'intensité (20) situé à l'intérieur de la transition-tunnel.

12. Ensemble de mesure selon l'une des revendications 9 à 11, dans lequel le résonateur est formé au moyen d'un premier miroir de résonateur (11, 12) et d'un deuxième miroir de résonateur (11, 12).

13. Ensemble de mesure selon la revendication 12, dans lequel le premier miroir de résonateur (11, 12) et/ou le deuxième miroir de résonateur (11, 12) sont configurés sous la forme de miroirs de Bragg.

14. Ensemble de mesure selon les revendications 12 ou 13, dans lequel au moins un miroir de résonateur (11, 12) est dopé.

15. Ensemble de mesure selon l'une des revendications 12 à 14, dans lequel les miroirs de résonateur (11, 12) présentent une des configurations suivantes : même type de conduction ou types de conduction différents.

16. Ensemble de mesure selon l'une des revendications 12 à 15, dans lequel les deux miroirs de résonateur (11, 12) présentent une conduction n.

17. Ensemble de mesure selon l'une des revendications 1 à 16, dans lequel le composant semi-conducteur (1) est configuré pour fonctionner comme composant laser semi-conducteur à pompage électrique.

18. Ensemble de mesure selon l'une des revendications 1 à 17, dans lequel le composant semi-conducteur (1) est configuré comme VCSEL.

19. Ensemble de mesure selon l'une des revendications 1 à 18, dans lequel deux des parties actives (4a, 4b) présentent une structure de puits quantique.

20. Ensemble de mesure selon l'une des revendications 1 à 19, dans lequel la transition-tunnel (5) présente deux couches-tunnel semi-conductrices (51, 52) de types différents de conduction.

21. Ensemble de mesure selon l'une des revendications 1 à 20, dans lequel le corps semi-conducteur (2) contient un matériau semi-conducteur III-V, en particulier un matériau du système de matériaux semi-conducteurs III-V InₓGa_{y}Al_{1-x-y}P, InₓGa_{y}Al_{1-x-y}N ou InₓGa_{y}Al_{1-x-y}As, chaque fois avec 0 ≤ x ≤ 1, 0 ≤ y ≤1 et x + y ≤ 1.

22. Ensemble de mesure selon l'une des revendications 1 à 21, dans lequel le corps semi-conducteur (2) contient un matériau semi-conducteur III-V, en particulier un matériau du système de matériaux semi-conducteurs III-V InGaAsN, InGaAsSb, InGaAsSbN ou In_{xG}a₁₋ₓAs_{y}P_{1-y} avec 0 ≤ x ≤1 et 0 ≤ y ≤1.

23. Ensemble de mesure selon l'une des revendications 1 à 22, dans lequel au moins deux des parties actives (4a, 4b) sont configurées pour émettre des rayonnements de différentes longueurs d'onde.

24. Ensemble de mesure selon l'une des revendications 1 à 23, dans lequel le dispositif de détection (DE) présente au moins un premier photo-élément semi-conducteur.

25. Ensemble de mesure selon la revendication 24, dans lequel le ou les premiers éléments photo-semi-conducteurs sont configurés comme photodiodes, comme phototransistors ou comme photorésistances.

26. Ensemble de mesure selon l'une des revendications 1 à 25, dans lequel un deuxième dispositif de détection (DE2) est prévu pour la détection du rayonnement réfléchi et est couplé au circuit d'évaluation (AS) en termes de commande et de traitement.

27. Ensemble de mesure selon l'une des revendications 1 à 26, dans lequel le dispositif (SE) d'émission de rayonnement présente plusieurs composants semi-conducteurs émettant en surface qui correspondent au premier composant semi-conducteur (1) émettant en surface.

28. Ensemble de mesure selon la revendication 27, dans lequel les différents composants semi-conducteurs émettant en surface sont disposés en champ de rayonnement unidimensionnel ou bidimensionnel.

29. Ensemble de mesure selon les revendications 27 ou 28, dans lequel l'émission d'un rayonnement par les différents composants semi-conducteurs émettant en surface peut être commandée séparément.

30. Ensemble de mesure selon l'une des revendications 27 à 29, dans lequel l'émission de rayonnement des différents composants semi-conducteurs émettant en surface peut s'effectuer en faisceau.

31. Ensemble de mesure selon l'une des revendications 1 à 30, dans lequel l'ensemble de mesure comporte au moins un élément optique de mise en forme du faisceau et/ou de guidage du faisceau émis par le dispositif (SE) d'émission de rayonnement.

32. Ensemble de mesure selon la revendication 31, dans lequel le ou les éléments optiques présentent au moins un des éléments suivants :
- un miroir,
- un interstice optique,
- une grille optique,
- un lentille,
- une fibre conduisant la lumière.

33. Ensemble de mesure selon l'une des revendications 1 à 32, dans lequel le circuit d'évaluation (AS) est conçu pour commander de manière pulsée l'émission de rayonnement par le premier composant semi-conducteur (1) émettant en surface.

34. Système de mesure doté d'un ensemble de mesure selon l'une des revendications 1 à 33, le système de mesure étant conçu pour mesurer des distances.

35. Système de mesure doté d'un ensemble de mesure selon l'une des revendications 1 à 33, le système de mesure étant conçu pour mesurer des vitesses.

36. Système de mesure doté d'un ensemble de mesure selon l'une des revendications 1 à 33, le système de mesure étant conçu comme régulateur temporisé de distance.
